# EUROPEAN PATENT APPLICATION

(11) **EP 4 668 018 A1**
(43) Date of publication of application: **24.12.2025**
(21) Application number: 24831567.3
(22) Date of filing: 03.06.2024
(51) Int. Cl.: G03F 7/038, C08G 59/40, C08G 59/62, C08G 73/10, G03F 7/004, H01L 23/29, H01L 23/31

(54) **NEGATIVE PHOTOSENSITIVE RESIN COMPOSITION, NEGATIVE PHOTOSENSITIVE RESIN COMPOSITION COATING, NEGATIVE PHOTOSENSITIVE RESIN COMPOSITION FILM, CURED FILM, AND SEMICONDUCTOR DEVICE USING THESE**

(30) Priority: 27.06.2023 JP 2023104744
(71) Applicant: Toray Industries, Inc., Tokyo 103-8666 (JP)
(72) Inventor: KATO, Keigo, Otsu-shi, Shiga 520-8558 (JP); MATSUMURA, Kazuyuki, Otsu-shi, Shiga 520-8558 (JP); TATEOKA, Yoshiko, Otsu-shi, Shiga 520-8558 (JP)
(74) Representative: Prüfer & Partner mbB Patentanwälte · Rechtsanwälte
(86) International application number: PCT/JP2024/020164
(87) International publication number: WO 2025/004697

(57) **Abstract**

Provided is a resin composition which exhibits excellent pattern processability in the form of a thick film and does not cause organic deposits even if processed on a substrate having an aluminum pad electrode. This negative photosensitive resin composition contains: at least one polymer compound selected from the group consisting of a polyamide, a polyimide, a polyamideimide and a polybenzoxazole as a component (A); a cationic polymerizable compound as a component (B); and a cationic photopolymerization initiator as a component (C). The negative photosensitive resin composition is characterized in that the content of fluorine atoms in the component (A) is 1 mass% or less.

## Description

### TECHNICAL FIELD

The present invention relates to a negative type photosensitive resin composition, a negative type photosensitive resin composition layer, a negative type photosensitive resin composition film, a cured layer, and semiconductor devices formed thereof. More specifically, it relates to a resin composition that can be suitably used to produce surface protection films or interlaminar insulation film for semiconductor elements and electronic components, structures for MEMS (microelectromechanical systems), or the like.

### BACKGROUND ART

Conventionally, polyimide based materials and polybenzoxazole based materials, which generally have high heat resistance, good electrical insulation properties, and good mechanical properties, have been widely used in surface protection films and interlaminar insulation films of semiconductor elements. In recent years, with the increasing demand for semiconductor devices with higher density and higher performance, photosensitive materials are now required for surface protection films and interlaminar insulating films from the standpoint of ensuring enhanced production efficiency.

As such photosensitive materials, those materials produced by imparting photosensitivity to polyimide based materials or polybenzoxazole based materials have been generally used. The use of these materials serves to simplify the pattern formation steps and shorten the complex pattern production steps. As one example of such photosensitive materials, positive type photosensitive polyimide materials have been proposed (for example, see Patent document 1). Patent document 1 describes that the use of a polyimide precursor or a polybenzoxazole precursor resin that are free of fluorine atoms serves to prevent the pad electrode portions from undergoing residue generation and corrosion, making it possible to produce semiconductor devices having organic insulating films with high reliability. However, in general, positive type photosensitive materials have a problem of difficulty in forming thick insulating films due to outgassing from photosensitizers and significant film loss during development. Furthermore, the use of a polyimide precursor or a polybenzoxazole precursor resin leads to a significant shrinkage during curing, which is also a reason for the difficulty in forming a thick insulating film.

On the other hand, as a photosensitive material, some documents have disclosed cationically polymerizable negative type photosensitive materials that contain a polymer compound such as polyimide, a cationically polymerizable compound such as epoxy compounds, and a cationic polymerization initiator (for example, see Patent document 2). When a negative type photosensitive material as disclosed in Patent document 2 is used, the influence of curing shrinkage can be reduced as compared to positive type photosensitive materials as proposed in Patent document 1, thereby enabling favorable patterning even in applications that require the formation of thick insulating films.

### PRIOR ART DOCUMENTS

### PATENT DOCUMENTS

Patent document 1: Japanese Unexamined Patent Publication (Kokai) No. 2009-283711
Patent document 2: Japanese Unexamined Patent Publication (Kokai) No. 2021-055055

### SUMMARY OF INVENTION

### PROBLEMS TO BE SOLVED BY THE INVENTION

However, as a disadvantage of the use of a cationically polymerizable negative type photosensitive material such as that proposed in Patent document 2, organic deposits are likely to be generated on the aluminum pad electrode portions if patterning is performed on a substrate having aluminum pad electrodes and followed by dry etching processing.

In view of such a situation, the present inventors conducted intensive investigations, and as a result, discovered that the use of a negative type photosensitive resin composition including a polymer compound such as polyimide having a fluorine atom content of 1 mass% or less, a cationically polymerizable compound, and a photocationic polymerization initiator serves to ensure a high patternability even in thick films and also prevent the occurrence of organic deposits even when processing is performed on a substrate having aluminum pad electrodes.

### MEANS OF SOLVING THE PROBLEMS

The present invention, which is designed for solving the above problems, has the features described below.
<1> A negative type photosensitive resin composition including at least one polymer compound selected from the group consisting of polyamide, polyimide, polyamide-imide, and polybenzoxazole, as a component (A), a cationically polymerizable compound as a component (B), and a photocationic polymerization initiator as a component (C), wherein the component (A) has a fluorine atom content of 1 mass% or less.
<2> A negative type photosensitive resin composition as set forth in the paragraph <1>, wherein the component (A) contains a diamine residue derived from at least one diamine as represented by any of the general formulae (1) to (4) given below: 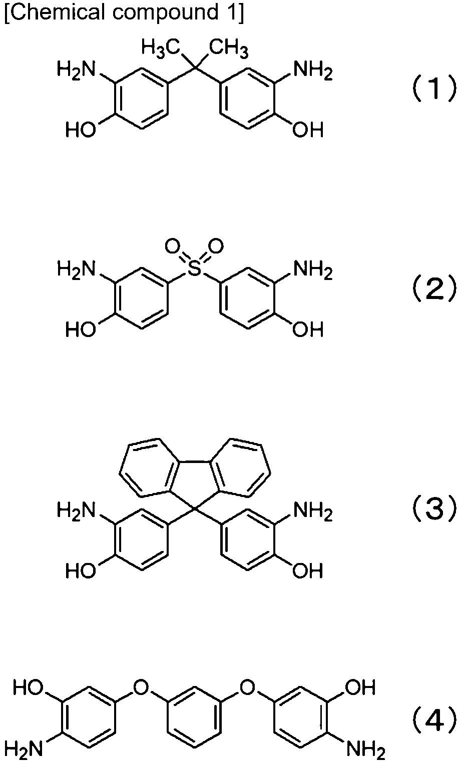
<3> A negative type photosensitive resin composition as set forth in the paragraph <2>, wherein diamine residues derived from diamines as represented by any of the general formulae (1) to (4) altogether account for 50 to 100 mol% of the total amount, which accounts for 100 mol%, of all diamine residues present in the component (A).
<4> A negative type photosensitive resin composition as set forth in the paragraph <2>, wherein diamine residues derived from diamines as represented by either the general formulae (3) or (4) altogether account for 50 to 100 mol% of the total amount, which accounts for 100 mol%, of all diamine residues present in the component (A).
<5> A negative type photosensitive resin composition as set forth in any one of the paragraphs <1> to <3>, wherein the component (A) contains a diamine residue derived from a diamine as represented by the general formula (5) given below: 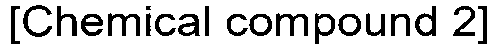 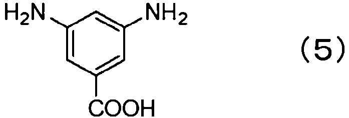
<6> A negative type photosensitive resin composition as set forth in any one of the paragraphs <1> to <4>, wherein the component (A) contains an alicyclic structure.
<7> A negative type photosensitive resin composition as set forth in any one of the paragraphs <1> to <5>, wherein the component (A) contains a carboxylic acid residue derived from an acid dianhydride as represented by the general formula (6) given below: 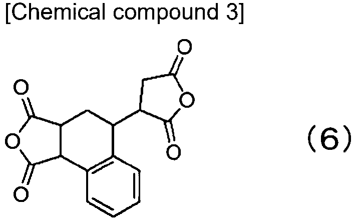
<8> A negative type photosensitive resin composition as set forth in the paragraph <4>, wherein the component (A) contains a diamine residue derived from a diamine and the component (A) also contains a carboxylic acid residue, with the ratio Y/X of the total amount of diamine residues to the total amount of all carboxylic acid residues being in the range of 0.55 to 0.85 where X moles represents the total content of carboxylic acid residues while Y moles represents the total content of diamine residues present in the component (A).
<9> A negative type photosensitive resin composition as set forth in any one of the paragraphs <1> to <7>, wherein the imidization rate of the component (A) is in the range of 70% to 100%.
<10> A negative type photosensitive resin composition layer including a negative type photosensitive resin composition as set forth in any one of the paragraphs <1> to <9>.
<11> A negative type photosensitive resin composition film including a negative type photosensitive resin composition layer as set forth in paragraph <10> and a support.
<12> A cured layer produced by curing either a negative type photosensitive resin composition as set forth in any one of the paragraphs <1> to <9> or a negative type photosensitive resin composition layer as set forth in the paragraph <10>.
<13> A semiconductor device including a cured layer as set forth in the paragraph <12>.
<14> A semiconductor device as set forth in the paragraph <13> having an aluminum pad electrode.

### ADVANTAGEOUS EFFECTS OF THE INVENTION

The present invention relates to a negative type photosensitive resin composition exhibiting a high patternability even in the form of a thick film and generating no organic deposits even when being processed on a substrate having an aluminum pad electrode and also relates to a negative type photosensitive resin composition layer, a negative type photosensitive resin composition film, a cured layer, and semiconductor devices formed thereof.

### DESCRIPTION OF PREFERRED EMBODIMENTS

The negative type photosensitive resin composition according to the present invention is a negative type photosensitive resin composition including at least one polymer compound selected from the group consisting of polyamide, polyimide, polyamide-imide, and polybenzoxazole, as a component (A), a cationically polymerizable compound as a component (B), and a photocationic polymerization initiator as a component (C), wherein the component (A) has a fluorine atom content of 1 mass% or less.

### <Component (A)>

The negative type photosensitive resin composition according to the present invention includes, as a component (A), at least one polymer compound (hereinafter occasionally referred to as the polymer compound (A)) selected from the group consisting of polyamide, polyimide, polyamideimide, and polybenzoxazole. As a result of containing the component (A), the negative type photosensitive resin composition according to the present invention exhibits a high film formability when being processed into a film.

There are no specific limitations on the weight average molecular weight of the component (A), but its weight average molecular weight is preferably 1,000 or more and 200,000 or less. The polymer compound (A) may be either a single polymer or a combination of two or more polymers. Here, for the present invention, the weight average molecular weight of the polymer compound (A) is measured by gel permeation chromatography (GPC) and converted in terms of polystyrene.

It is essential that the negative type photosensitive resin composition according to the present invention include at least one polymer compound selected from the group consisting of polyamide, polyimide, polyamide-imide, and polybenzoxazole, and if it includes at least one polymer compound selected from the group consisting of polyamide, polyimide, polyamide-imide, and polybenzoxazole, it may further include a polymer compound other than polyamide, polyimide, polyamide-imide, or polybenzoxazole. It should be noted that polyimide precursors and polybenzoxazole precursors fall under the above category of polyamide.

For the present invention, the component (A) mentioned above is preferably a compound having at least one structure selected from the group consisting of the structures represented by the general formula (7) or the general formula (8).

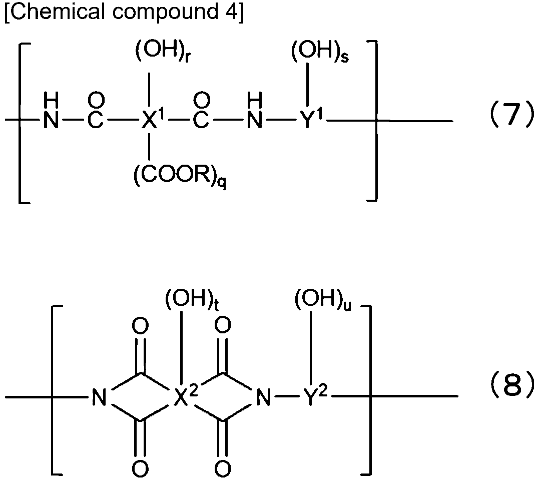

(In the general formulae (7) and (8), X¹ and X² each independently represent a divalent to decavalent organic group; Y¹ and Y² each independently represent a divalent to tetravalent organic group; and R represents a hydrogen atom or an organic group having 1 to 20 carbon atoms. In addition, q is an integer of 0 to 2, and r, s, t, and u are each independently an integer of 0 to 4.)

In the general formulae (7) and (8), X¹ and X² are each independently a divalent to decavalent organic group that is a carboxylic acid residue. Here, a carboxylic acid residue is a structure derived from a compound such as a dicarboxylic acid, dicarboxylic acid chloride compound, tetracarboxylic acid, or acid dianhydride that is used for direct polymerization reaction thereof and serves to form a polyamide, polyimide, polyamide-imide, or polybenzoxazole. For example, in the case where an acid dianhydride a is subjected first to a chemical reaction to form an acid dianhydride b, followed by subjecting the acid dianhydride b to a polymerization reaction to produce a polyimide c, the carboxylic acid residue in the polyimide c is the acid dianhydride b, and the acid dianhydride a is not the carboxylic acid residue in the polyimide c. Y¹ and Y² are each a divalent to tetravalent organic group that represents a diamine residue. Here, a diamine residue is a structure that is derived from a diamine used for direct polymerization reaction thereof and serves to form polyamide, polyimide, polyamide-imide, or polybenzoxazole. For example, in the case where a diamine a is subjected first to a chemical reaction to form a diamine b, followed by subjecting the diamine b to a polymerization reaction to produce a polyimide d, the diamine residue in the polyimide d is the diamine b, and the diamine a is not the diamine residue in the polyimide d.

For the present invention, the content of fluorine atoms in the component (A) is 1 mass% or less. If the content of fluorine atoms in the component (A) is 1 mass% or less, it becomes less likely for organic deposits to be formed as a result of a reaction between a fluorine-containing gas used for dry etching and the organic components present in the negative type photosensitive resin composition according to the present invention. From the perspective of inhibiting the formation of the above organic deposits, it is preferable for the content of fluorine atoms in the component (A) to be 0.1 mass% or less, and more preferably 0.01 mass% or less. Such a component (A) having a fluorine atom content of 1 mass% or less or a component (A) having a fluorine atom content in the preferable range specified above can be obtained by reacting a dicarboxylic acid, dicarboxylic acid chloride compound, tetracarboxylic acid, or acid dianhydride that does not contain fluorine atoms with a diamine that does not contain fluorine atoms either.

Furthermore, it is preferable for the component (A) to contain a diamine residue derived from at least one diamine as represented by any of the general formulae (1) to (4).

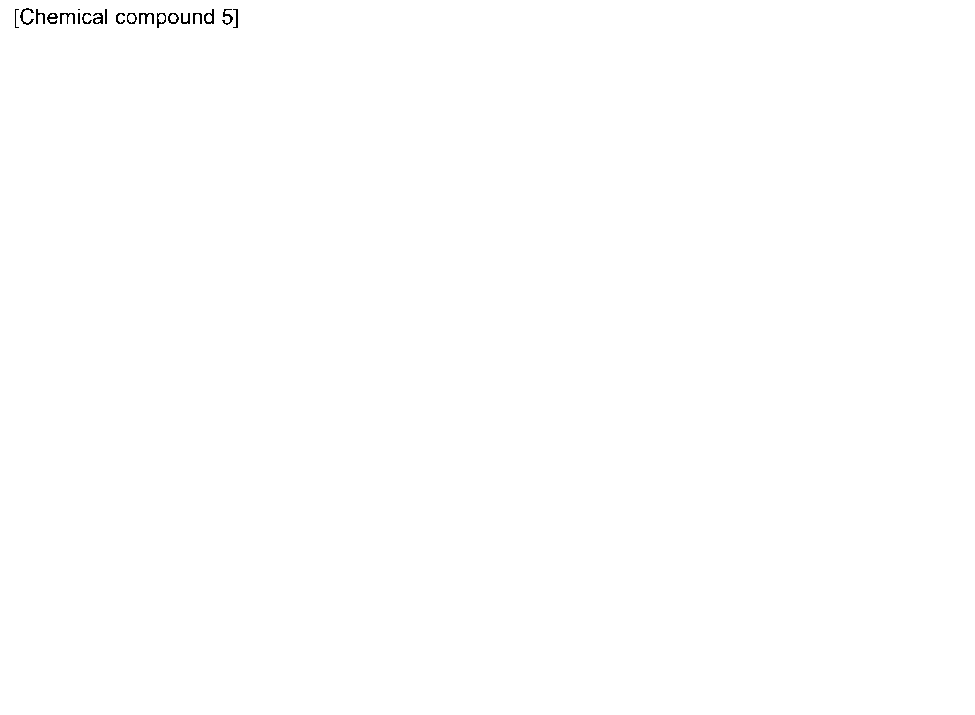

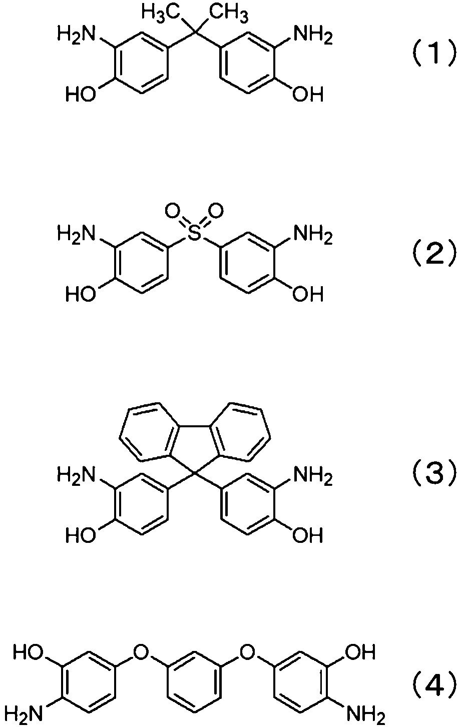

If the component (A) contains a diamine residue derived from at least one diamine as represented by any of the general formulae (1) to (4), it is preferable because it enables the production of a negative type photosensitive resin composition that exhibits high processability in a patterning step using a low environmental-impact alkaline aqueous solution as the developer. Furthermore, it is preferable also because it serves to produce a negative type photosensitive resin composition with high chemical resistance as a result of a crosslinking reaction of the phenolic hydroxyl group contained in the diamine residue derived from a diamine as represented by the general formulae (1) to (4) with the cationically polymerizable compound (B) during a curing step performed at a high temperature.

Furthermore, relative to the total amount, which accounts for 100 mol%, of all diamine residues in the component (A), it is preferable that the total amount of diamine residues derived from diamines as represented by the general formulae (1) to (4) accounts for 50 to 100 mol%, more preferably 70 to 100 mol%. If the total amount of diamine residues derived from diamines as represented by general formulae (1) to (4) accounts for a proportion in the preferable range, it is preferable because it allows the negative type photosensitive resin composition to have a higher alkali solubility, leading to an enhanced resolution during the patterning step.

Furthermore, it is preferable that the diamine residues derived from diamines as represented by the general formulae (3) or (4) altogether account for 50 to 100 mol%, more preferably 70 to 100 mol%, of the total amount, which accounts for 100 mol%, of all diamine residues present in the component (A). If the total amount of diamine residues derived from diamines represented by the general formula (3) or (4) accounts for a proportion in the preferable range, it is preferable because it leads to an enhanced resolution during the patterning step due to the effect of enhanced solubility brought about by the cardo structure contained in the diamine represented by the general formula (3) or due to the effect of enhanced solubility brought about by the phenylene ether linkage contained in the diamine represented by the general formula (4).

Furthermore, in the case where the total amount of diamine residues derived from diamines as represented by the general formula (3) or (4) accounts for 50 to 100 mol% of the total content, which accounts for 100 mol%, of all diamine residues in the component (A), it is preferable that the ratio Y/X of the total amount of diamine residues to the total amount of all carboxylic acid residues, where X moles represents the total content of carboxylic acid residues while Y moles represents the total content of diamine residues present in the component (A), be in the range of 0.55 to 0.85, more preferably 0.58 to 0.75. The negative type photosensitive resin composition forms a cured layer that exhibits sufficient heat resistance if the ratio Y/X of the total amount of diamine residues to the total amount of all carboxylic acid residues is equal to or higher than the lower limit of the preferable range, whereas the resolution is further improved without suffering from a decrease in sensitivity during the patterning step if the ratio is equal to or lower than the upper limit of the preferable range, which are therefore preferable.

In addition, it is preferable that the component (A) include a diamine residue derived from a diamine as represented by the general formula (5).

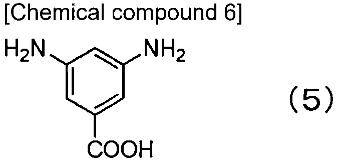

If the component (A) contains a diamine residue derived from a diamine as represented by the general formula (5), it is preferable because it enables the production of a negative type photosensitive resin composition with high processability in a patterning step using a low environmental-impact alkaline aqueous solution as the developer. Furthermore, it is preferable because it enables the production of a negative type photosensitive resin composition with high chemical resistance as a result of a crosslinking reaction of the carboxyl group contained in the diamine residue derived from a diamine as represented by the general formula (5) with the cationically polymerizable compound (B) during a curing step performed at a high temperature. It is preferable also because it enables the production of a negative type photosensitive resin composition with high processability as a result of the presence of a diamine residue derived from a diamine as represented by the general formula (5), which acts to enhance transparency though an unknown mechanism.

The diamine residue in the component (A) may contain a diamine residue having an aromatic ring other than those mentioned above. If such components are copolymerized, it serves to increase the heat resistance. Specific examples of diamine residues having aromatic rings include, but not limited to, aromatic diamines such as 3,4'-diaminodiphenyl ether, 4,4'-diaminodiphenyl ether, 3,4'-diaminodiphenyl methane, 4,4'-diaminodiphenyl methane, 3,4'-diaminodiphenyl sulfone, 4,4'-diaminodiphenyl sulfone, 3,4'-diaminodiphenyl sulfide, 4,4'-diaminodiphenyl sulfide, 1,4-bis(4-aminophenoxy)benzene, benzine, m-phenylene diamine, p-phenylene diamine, 1,5-naphthalene diamine, 2,6-naphthalene diamine, bis(4-aminophenoxyphenyl) sulfone, bis(3-aminophenoxyphenyl) sulfone, bis(4-aminophenoxy)biphenyl, bis{4-(4-aminophenoxy)phenyl} ether, 1,4-bis(4-aminophenoxy)benzene, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2',3,3'-tetramethyl-4,4'-diaminobiphenyl, 3,3',4,4'-tetramethyl-4,4'-diaminobiphenyl, and 2,2'-bis(trifluoromethyl)-4,4'-diaminobiphenyl, as well as compounds derived therefrom by substituting part of the hydrogen atoms in the aromatic rings and/or hydrocarbons with alkyl groups having 1 to 10 carbon atoms, fluoroalkyl groups, halogen atoms, or the like.

The diamine residue in the component (A) may contain a silicone diamine residue. If such components are copolymerized, it is expected to work to increase the solubility, insulation properties, etc. Specific examples of silicone diamine residues include, but not limited to, 1,3-bis(3-aminopropyl)-1,1,3,3-tetramethyldisiloxane, 1,3-bis(p-aminophenyl)-1,1,3,3-tetramethyldisiloxane, 1,3-bis(p-aminophenethyl)-1,1,3,3-tetramethyldisiloxane, and 1,7-bis(p-aminophenyl)-1,1,3,3,5,5,7,7-octamethyltetrasiloxane. Other diamines to use for copolymerization may be in their original forms or in the form of their corresponding diisocyanate compounds or trimethylsilylated diamines. It may also be effective to use two or more of these diamine components in combination. In the case where the component (A) contains both a diamine residue as represented by any of the general formulas (1) to (4) and a silicone diamine residue, it is preferred that the total content of silicone diamine residues be 3 to 30 mol%, more preferably 5 to 20 mol%, of the total amount, which accounts for 100 mol%, of the total diamine residues. If the content of silicone diamine residues is equal to or higher than the lower limit of the preferable range, it is preferable because it serves to improve the solubility of the component (A), which in turn enhances its resolution. If the content of silicone diamine residues is equal to or lower than the upper limit of the preferable range, it is preferable because it allows the component (A) to have a sufficient alkali solubility, which in turn enhances its resolution.

In the case where the component (A) contains both a diamine residue as represented by the general formula (5) and a silicone diamine residue, it is preferable that the total content of silicone diamine residues be 10 to 80 mol%, more preferably 30 to 70 mol%, and particularly preferably 40 to 60 mol%, of the total content, which accounts for 100 mol%, of all diamine residues. If the content of silicone diamine residues is equal to or higher than the lower limit of the preferable range, it is preferable because it serves to improve the solubility of the component (A), which in turn enhances its resolution. It is preferable also because it serves to improve the insulation properties. If the content of silicone diamine residues is equal to or lower than the upper limit of the preferable range, it is preferable because it allows the component (A) to have a sufficient alkali solubility, which in turn enhances its resolution.

In addition, it is preferable for the component (A) to have an alicyclic structure. If the component (A) has an alicyclic structure, it serves to allow the negative type photosensitive resin composition to have enhanced transparency, leading to enhanced patternability. In addition, it is preferable for the component (A) to contain a carboxylic acid residue having an alicyclic structure from the viewpoint of providing a negative type photosensitive resin having improved solubility. Specific examples of favorable carboxylic dianhydrides having alicyclic structures include 1,2,3,4-butanetetracarboxylic dianhydride, 1,2,3,4-cyclobutanetetracarboxylic dianhydride, 1,1'-bicyclohexane-3,3',4,4'-tetracarboxylic-3,4:3',4'-dianhydride, 4-(2,5-dioxotetrahydrofuran-3-yl)-1,2,3,4-tetrahydronaphthalene-1,2-dicarboxylic dianhydride, 4-(2,5-dioxotetrahydrofuran-3-yl)-4-methyl-1,2,3,4-tetrahydronaphthalene-1,2-dicarboxylic dianhydride, 4-(2,5-dioxotetrahydrofuran-3-yl)-7-methyl-1,2,3,4-tetrahydronaphthalene-1,2-dicarboxylic dianhydride, norbornane-2-spiro-2'-cyclopentanone-5'-spiro-2"-norbornane-5,5",6,6"-tetracarboxylic dianhydride, and norbornane-2-spiro-2'-cyclohexanone-6'-spiro-2"-norbornane-5,5",6,6"-tetracarboxylic dianhydride.

Furthermore, it is preferable that the component (A) contains a carboxylic acid residue derived from an acid dianhydride as represented by the general formula (6) given below.

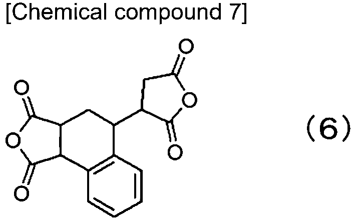

If the component (A) contains a carboxylic acid residue derived from an acid dianhydride as represented by the general formula (6), it is preferable not only because it ensures an increase in solubility to improve resolution but also because it allows the negative type photosensitive resin composition to form a cured product with an increased chemical resistance, leading to improved resistance to ion migration.

In regard to the carboxylic acid residues described above, it may further contain an carboxylic acid residue other than the aforementioned carboxylic acid residues having an alicyclic structure. Specific examples thereof include, but not limited to, aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, bis(3,4-dicarboxyphenyl)sulfone dianhydride, bis(3,4-dicarboxyphenyl)ether dianhydride, 1,2,5,6-naphthalenetetracarboxylic dianhydride, 9,9-bis(3,4-dicarboxyphenyl)fluorene dianhydride, 9,9-bis{4-(3,4-dicarboxyphenoxy)phenyl}fluorene dianhydride, 2,3,6,7-naphthalenetetracarboxylic dianhydride, 2,3,5,6-pyridinetetracarboxylic dianhydride, 3,4,9,10-perylenetetracarboxylic dianhydride, and 2,2-bis(3,4-dicarboxyphenyl)hexafluoropropane dianhydride, as well as others such as 3,3',4,4'-diphenylsulfonetetracarboxylic dianhydride, 1,2,3,4-cyclobutanetetracarboxylic dianhydride, 1,2,3,4-cyclopentanetetracarboxylic dianhydride, 1,2,4,5-cyclohexanetetracarboxylic dianhydride, 5-(2,5-dioxotetrahydrofuryl)-3-methyl-3-cyclohexene-1,2-dicarboxylic dianhydride, 2,3,5-tricarboxy-2-cyclopentaneacetic dianhydride, and 2,3,4,5-tetrahydrofuranetetracarboxylic dianhydride. Here, these may be used singly or as a combination of two or more thereof.

It is preferable that the component (A) have an imidization rate of 70% to 100%, more preferably 90% to 100%. If the component (A) has an imidization rate in the preferable range, it is preferable because it ensures a decrease in the content of amide groups, which can act to inhibit the reactivity of the cationically polymerizable compound (B), leading to an improved sensitivity during the patterning step. It is preferable also because it acts to decrease the change in the imide ring-closure rate during thermal curing of the negative type photosensitive resin composition, leading to a smaller shrinkage during the curing step to ensure a lower stress.

For the present invention, the imidization rate can be easily determined by, for example, the method described below. First, an infrared absorption spectrum of the polymer under examination is measured to confirm the presence of absorption peaks of the imide structure attributed to polyimide (near 1,780 cm⁻¹ and near 1,377 cm⁻¹). Then, the polymer is heat-treated at 350°C for 1 hour to provide a sample with an imidization rate of 100% and its infrared absorption spectrum is observed. Based on a comparison of peak intensity of the resin near 1,377 cm⁻¹ measured before heat treatment and that after heat treatment, the imide group content in the resin before heat treatment is calculated and then used to determine the imidization rate.

**It** is also preferable for the component (A) to have a molecular chain end structure that is derived from a carboxylic acid residue. If a structure derived from a carboxylic acid residue is present at the molecular chain end of the component (A), it is possible to form a molecular structure in which the molecular chain ends are devoid of amine-terminated structures that can act as functional groups working to inhibit cationic polymerization, and as a result, it serves to develop sufficiently high cationic polymerizability. Here, the expression "a structure derived from a carboxylic acid residue is present at the molecular chain end of the component (A)" suggests that an organic group that is derived from a carboxylic acid residue and serves to form a polyamide, polyimide, or polyamide-imide is located at the molecular chain end and examples of such a structure include monocarboxylic acids, dicarboxylic acids, monocarboxylic acid chloride compounds, dicarboxylic acid chloride compounds, tetracarboxylic acids, anhydrides, and dianhydrides.

Examples of structures (organic groups) derived from carboxylic acid residues located at the molecular chain end of the component (A) include, but not limited to, aromatic dicarboxylic acids, aromatic acid dianhydrides, alicyclic dicarboxylic acids, alicyclic acid dianhydrides, aliphatic dicarboxylic acids, and aliphatic acid dianhydrides. Here, these may be used singly or as a combination of two or more thereof.

The molar ratio of structures as represented by the general formula (6) or (7) can be determined by an appropriate method such as calculation from the molar ratio of the monomers used in the polymerization or detection of peaks attributed to polyamide structures, imide precursor structures, and/or imide structures in the resulting resin, resin composition, or cured layer analyzed by means of a nuclear magnetic resonance (NMR) device.

As an example of the component (A) in which the molecular chain end has a structure derived from a carboxylic acid residue, a polyimide in which the molecular chain end has a structure derived from a carboxylic acid residue can be produced by using an excessive amount of an acid anhydride relative to the diamine employed in the polymerization reaction. Alternatively, another good method to produce the component (A) in which the molecular chain end has a structure derived from a carboxylic acid residue is to use a specific compound selected from among compounds generally used as chain terminators. Specific examples thereof include acid anhydrides, monocarboxylic acids, monocarboxylic chloride compounds, and mono-active ester compounds.

Furthermore, if a carboxyl acid or acid anhydride having a hydroxyl group, carboxyl acid group, sulfonic acid group, thiol group, vinyl group, ethynyl group, or allyl group is used as an end capping agent to cap the molecular chain end of the component (A), it serves to allow the dissolution rate of the component (A) in an alkaline aqueous solution and the mechanical properties of the intended cured layer to be easily controlled in desirable ranges. In addition, a plurality of different end capping agents may be reacted to introduce a plurality of different chain end groups.

Examples of acid anhydrides, monocarboxylic acids, monocarboxylic acid chloride compounds, and mono-active ester compounds that are suitable for use as end capping agents include acid anhydrides such as phthalic anhydride, maleic anhydride, nadic anhydride, cyclohexanedicarboxylic anhydride, and 3-hydroxyphthalic anhydride; monocarboxylic acids such as 3-carboxyphenol, 4-carboxyphenol, 3-carboxythiophenol, 4-carboxythiophenol, 1-hydroxy-7-carboxynaphthalene, 1-hydroxy-6-carboxynaphthalene, 1-hydroxy-5-carboxynaphthalene, 1-mercapto-7-carboxynaphthalene, 1-mercapto-6-carboxynaphthalene, 1-mercapto-5-carboxynaphthalene, 3-carboxybenzene sulfonic acid, and 4-carboxybenzene sulfonic acid; monocarboxylic chloride compounds produced therefrom by converting their carboxyl group into an acid chloride group; monocarboxylic chloride compounds produced from dicarboxylic acids such as terephthalic acid, phthalic acid, maleic acid, cyclohexane dicarboxylic acid, 1,5-dicarboxynaphthalene, 1,6-dicarboxynaphthalene, 1,7-dicarboxynaphthalene, and 2,6-dicarboxynaphthalene by converting only one of their carboxyl groups into an acid chloride group; and active ester compounds produced by reacting a monocarboxylic chloride compound with N-hydroxybenzotriazole, imidazole, or N-hydroxy-5-norbornene-2,3-dicarboxyimide. Two or more of these may be used in combination.

If such an end capping agent is introduced into a polymer compound, it serves to as a component (A) having a structure derived from a carboxylic acid residue located at the molecular chain end. Here, an end capping agent that can be used to produce a component (A) having a structure derived from a carboxylic acid residue located at the molecular chain end can be easily detected by such methods as described below. For example, such a component (A) containing an end capping agent is dissolved in an acidic solution to decompose it into its constituent amine and acid anhydride components and analyzing these components by means of gas chromatography (GC), NMR spectroscopy, etc. This serves for easy detection of the end capping agent used for the present invention. In another method, detection can be carried out easily by subjecting the resin component containing an end capping agent directly to pyrolysis gas chromatography (PGC), infrared spectroscopy, or 13C-NMR spectroscopy.

For the present invention, the component (A) can be synthesized by, for example, the method described below, although the invention is not limited thereto. A polyimide structure can be synthesized through a generally known process designed to replace part of the diamine with a primary monoamine used as end capping agent or replace the tetracarboxylic dianhydride with a dicarboxylic anhydride used as end capping agent. For example, a polyimide precursor is prepared through a process in which a tetracarboxylic dianhydride, a diamine compound, and a monoamine are reacted at a low temperature, a process in which a tetracarboxylic dianhydride, a dicarboxylic anhydride, and a diamine compound are reacted at a low temperature, or a process in which a tetracarboxylic dianhydride and an alcohol are reacted to form a diester, which is then reacted in the presence of a diamine, a monoamine, and a condensation agent. Subsequently, a polyimide can be synthesized by a generally known imidization reaction method.

For the present invention, after being polymerized by such a method as described above, the resulting component (A) is preferably precipitated by adding a large amount of water or a liquid mixture of methanol and water and then filtered, dried, and isolated. The drying temperature is preferably 40°C to 100°C, more preferably 50°C to 80°C. This step serves to remove unreacted monomers and oligomers such as dimmers and trimers to allow a film with improved properties to be obtained after heat curing.

The component (A) preferably accounts for a total of 15 to 70 mass%, more preferably 25 to 60 mass%, of the total mass, which accounts for 100%, of the resin composition according to the present invention. If the component (A) accounts for 15 mass% or more of the total mass, which accounts for 100%, of the resin composition, it is preferable because it enables improvement in mechanical properties and thermal properties, whereas if it accounts for 70 mass% or less, it is preferable because it allows for a reduction in development residue.

### <Component (B)>

The negative type photosensitive resin composition according to the present invention includes a cationically polymerizable compound as the component (B) (hereinafter occasionally referred to as cationically polymerizable compound (B)). Due to the inclusion of the cationically polymerizable compound (B), the negative type photosensitive resin composition according to the present invention undergoes photocationic polymerization, leading to high negative type patternability.

Favorable substances to use as the cationically polymerizable compound (B) include cyclic ether compounds (such as epoxy compounds and oxetane compounds), ethylenically unsaturated compounds (such as vinyl ethers and styrene compounds), bicyclo-orthoesters, spiro-orthocarbonates, and spiro-orthoesters.

Generally known epoxy compounds can be used, and favorable ones include aromatic epoxy compounds, alicyclic epoxy compounds, and aliphatic epoxy compounds.

Examples of favorable aromatic epoxy compounds include glycidyl ethers of monovalent or polyvalent phenols having at least one aromatic ring (such as phenol, bisphenol A, phenol novolac, and alkylene oxide adducts thereof).

Examples of favorable alicyclic epoxy compounds include compounds obtainable by epoxidizing a compound having at least one cyclohexene or cyclopentene ring using an oxidizing agent (such as 3,4-epoxycyclohexylmethyl-3,4-epoxycyclohexane carboxylate).

Examples of favorable aliphatic epoxy compounds include polyglycidyl ethers of aliphatic polyhydric alcohols or their alkylene oxide adducts (such as 1,4-butanedioldiglycidyl ether and 1,6-hexanedioldiglycidyl ether), polyglycidyl esters of aliphatic polybasic acids (such as diglycidyl tetrahydrophthalate), and epoxidized compounds of long-chain unsaturated compounds (such as epoxidized soybean oil and epoxidized polybutadiene).

Examples of favorable oxetane compounds include generally known compounds such as 3-ethyl-3-hydroxymethyl oxetane, 2-ethylhexyl(3-ethyl-3-oxetanylmethyl)ether, 2-hydroxyethyl(3-ethyl-3-oxetanylmethyl)ether, 2-hydroxypropyl(3-ethyl-3-oxetanylmethyl)ether, 1,4-bis[(3-ethyl-3-oxetanylmethoxy)methyl] benzene, oxetanyl silsesquioxetane, and phenolnovolac oxetane.

Examples of favorable ethylenically unsaturated compounds include generally known cationically polymerizable monomers such as aliphatic monovinyl ethers, aromatic monovinyl ethers, polyfunctional vinyl ethers, styrenes, and cationically polymerizable nitrogen-containing monomers.

Examples of favorable aliphatic monovinyl ethers include methylvinyl ether, ethylvinyl ether, butylvinyl ether, and cyclohexylvinyl ether.

Examples of favorable aromatic monovinyl ethers include 2-phenoxyethylvinyl ether, phenylvinyl ether, and p-methoxyphenylvinyl ether.

Examples of favorable polyfunctional vinyl ethers include butanediol-1,4-divinyl ether and triethylene glycol divinyl ether.

Examples of favorable styrene compounds include styrene, α-methyl styrene, p-methoxystyrene, and p-tert-butoxystyrene.

Examples of favorable cationically polymerizable nitrogen-containing monomers include N-vinylcarbazol and N-vinylpyrrolidone.

Examples of favorable bicyclo-orthoesters include 1-phenyl-4-ethyl-2,6,7-trioxabicyclo[2.2.2]octane and 1-ethyl-4-hydroxymethyl-2,6,7-trioxabicyclo-[2.2.2]octane.

Examples of favorable spiro-orthocarbonates include 1,5,7,11-tetraoxaspiro[5.5]undecane and 3,9-dibenzyl-1,5,7,11-tetraoxaspiro[5.5]undecane.

Examples of favorable spiro-orthoesters include 1,4,6-trioxaspiro[4.4]nonane, 2-methyl-1,4,6-trioxaspiro[4.4]nonane, and 1,4,6-trioxaspiro[4.5]decane.

Of these cationically polymerizable compounds, preferable are epoxy compounds, oxetane compounds, and vinyl ethers, and more preferable are epoxy compounds and oxetane compounds.

The inclusion of an epoxy compound with an isocyanurate skeleton as the cationically polymerizable compound (B) serves to allow the resin composition to form a cured layer having a low dielectric constant and low dielectric loss tangent while maintaining cationic polymerizability. If applied to development with an alkaline aqueous solution, furthermore, although the mechanism is not entirely clear, such a compound, which itself is not soluble in an alkaline aqueous solution, can mix in a miscible way with an alkali-soluble polymer compound (A) so that a resin composition that can undergo patterning in an alkaline aqueous solution is formed without impairing its alkali solubility.

Favorable examples of such an epoxy compound having an isocyanurate skeleton include triglycidyl isocyanurates such as TEPIC-S, TEPIC-L, TEPIC-VL, TEPIC-PASB26L, TEPIC-PASB22, TEPIC-FL, and TEPIC-UC (all trade names, manufactured by Nissan Chemical Corporation).

If an epoxy compound having an isocyanurate skeleton is incorporated as the cationically polymerizable compound (B), it preferably accounts for 40 mass% or more, more preferably 60 mass% or more, relative to the total mass, which accounts for 100 mass%, of the cationically polymerizable compound (B). Here, the upper limit of the content of the epoxy compound having an isocyanurate skeleton is 100 mass%.

Furthermore, if a multifunctional epoxy compound that is in a liquid state at room temperature is used as the cationically polymerizable compound (B), it is preferable because it ensures higher compatibility with the polymer compound (A) and serves to achieve fine patternability. In this case, it is preferable for the multifunctional epoxy compound to have an epoxy equivalent weight of 80 g/eq or more and 160 g/eq or less. When cured, the multifunctional epoxy compound having an epoxy equivalent weight of 80 g/eq or more and 160 g/eq or less can form a cured layer having improved heat resistance and chemical resistance. It is more preferable for the multifunctional epoxy compound to have an epoxy equivalent weight of 80 g/eq or more and 150 g/eq or less, more preferably 85 g/eq or more and 130 g/eq or less.

Favorable examples of such a multifunctional epoxy compound that is in a liquid state at room temperature and has an epoxy equivalent weight of 80 g/eq or more and 160 g/eq or less include TEPIC-VL (trade name, manufactured by Nissan Chemical Corporation), bisphenol A type epoxy compounds, bisphenol F type epoxy compounds, Shofree BATG, and Shofree PETG (trade names, both manufactured by Resonac Corporation), of which TEPIC-VL, Shofree BATG, and Shofree PETG are more preferable from the viewpoint of resolution.

Furthermore, if a difunctional or higher oxetane compound is included as the cationically polymerizable compound (B), it is preferable because it serves to increase the cationic polymerization reactivity and improve sensitivity during the patterning step. It is preferable also because the resulting cured layer is low in hydroxyl group concentration to reduce the water absorption, leading to increased insulation reliability.

Examples of favorable difunctional or higher oxetane compounds include OXT-121 and OXT-221 (both trade names, manufactured by Toagosei Co., Ltd.), as well as ETERNACOLL OXBP and ETERNACOLL OXIPA (both trade names, manufactured by UBE Corporation), of which OXT-121 and ETERNACOLL OXBP are more preferable from the viewpoint of resolution. These substances for the cationically polymerizable compound (B) may be used singly or as a mixture of two or more thereof.

In regard to the content of the cationically polymerizable compound (B) to ensure sufficient cationic curability and improved patternability, it is preferable that the cationically polymerizable compound (B) account for 30 parts by mass or more, more preferably 50 parts by mass or more, relative to 100 parts by mass of the polymer compound (A). On the other hand, when processing it into a film-like shape to form a resin composition layer, it is preferable that the cationically polymerizable compound (B) account for 200 parts by mass or less, more preferably 150 parts by mass or less relative to 100 parts by mass of the polymer compound (A) in order to allow the resin composition layer to have no surface tackiness and high handleability and form a cured layer with increased strength and elongation.

### <Component [C]>

The negative type photosensitive resin composition according to the present invention includes a photocationic polymerization initiator as component (C) (hereinafter occasionally referred to as photocationic polymerization initiator (C)). The component (C) is designed to generate an acid when receiving light and cause cationic polymerization.

Generally known compounds can be used as the component (C), but it is preferable that the component (C) contain a sulfonium salt, in which at least one selected from the group consisting of borate ions, phosphate ions, and gallate ions is contained as a counter anion to form the sulfonium salt. If the component (C) contains a sulfonium salt and contains at least one selected from the group consisting of borate ions, phosphate ions, and gallate ions as a counter anion to form the sulfonium salt, it is preferable because the cationic polymerization of the component (B) proceeds to a sufficient degree during the patterning step to enable the production of a favorable pattern.

Examples of favorable cations to form such a sulfonium salt include, but not limited to, triaryl sulfoniums such as triphenyl sulfonium, tri-p-tolyl sulfonium, tris-(4-methoxyphenyl) sulfonium, 1-naphthyldiphenyl sulfonium, 2-naphthyldiphenyl sulfonium, tris-(4-fluorophenyl) sulfonium, tri-1-naphthyl sulfonium, tri-2-naphthyl sulfonium, tris-(4-hydroxyphenyl) sulfonium, 4-(phenylthio)phenyldiphenyl sulfonium, 4-(p-tolylthio)phenyl-di-p-tolyl sulfonium, 4-(4-methoxyphenylthio)phenyl-bis(4-methoxyphenyl) sulfonium, 4-(phenylthio)phenyl-bis(4-fluorophenyl) sulfonium, 4-(phenylthio)phenyl-bis(4-methoxyphenyl) sulfonium, 4-(phenylthio)phenyl di-p-tolyl sulfonium, [4-(4-biphenylylthio)phenyl]-4-biphenylylphenyl sulfonium, [4-(2-thioxantonylthio)phenyl]diphenyl sulfonium, bis[4-(diphenylsulfonio)phenyl] sulfide, bis[4-{bis[4-(2-hydroxyethoxy)phenyl]sulfonio}phenyl] sulfide, bis{4-[bis(4-fluorophenyl)sulfonio]phenyl} sulfide, bis{4-[bis(4-methylphenyl)sulfonio]phenyl} sulfide, bis{4-[bis(4-methoxyphenyl)sulfonio]phenyl} sulfide, 4-(4-benzoyl-2-chlorophenylthio)phenyl-bis(4-fluorophenyl) sulfonium, 4-(4-benzoyl-2-chlorophenylthio)phenyldiphenyl sulfonium, 4-(4-benzoylphenylthio)phenyl-bis(4-fluorophenyl) sulfonium, 4-(4-benzoylphenylthio)phenyldiphenyl sulfonium, 7-isopropyl-9-oxo-10-thia-9,10-dihydroanthracene-2-yl-di-p-tolyl sulfonium, 7-isopropyl-9-oxo-10-thia-9,10-dihydroanthracene-2-yl-diphenyl sulfonium, 2-[(di-p-tolyl)sulfonio]thioxanthone, 2-[(diphenyl)sulfonio]thioxanthone, 4-(9-oxo-9H-thioxanthene-2-yl)thiophenyl-9-oxo-9H-thioxanthene-2-ylphenyl sulfonium, 4-[4-(4-tert-butylbenzoyl)phenylthio]phenyl-di-p-tolyl sulfonium, 4-[4-(4-tert-butylbenzoyl)phenylthio]phenyldiphenyl sulfonium, 4-[4-(benzoylphenylthio)]phenyl-di-p-tolyl sulfonium, 4-[4-(benzoylphenylthio)]phenyldiphenyl sulfonium, 5-(4-methoxyphenyl)thianthrenium, 5-phenyl thianthrenium, 5-tolyl thianthrenium, 5-(4-ethoxyphenyl) thianthrenium, and 5-(2,4,6-trimethylphenyl) thianthrenium; diaryl sulfoniums such as diphenylphenacyl sulfonium, diphenyl-4-nitrophenacyl sulfonium, diphenylbenzyl sulfonium, and diphenylmethyl sulfonium; monoaryl sulfoniums such as phenylmethylbenzyl sulfonium, 4-hydroxyphenylmethylbenzyl sulfonium, 4-methoxyphenylmethylbenzyl sulfonium, 4-acetocarbonyloxyphenylmethylbenzyl sulfonium, 4-hydroxyphenyl(2-naphthylmethyl)methyl sulfonium, 2-naphthylmethylbenzyl sulfonium, 2-naphthylmethyl(1-ethoxycarbonyl)ethyl sulfonium, phenylmethylphenacyl sulfonium, 4-hydroxyphenylmethylphenacyl sulfonium, 4-methoxyphenylmethylphenacyl sulfonium, 4-acetocarbonyloxyphenylmethylphenacyl sulfonium, 2-naphthylmethylphenacyl sulfonium, 2-naphthyloctadecylphenacyl sulfonium, and 9-anthracenylmethylphenacyl sulfonium; and others such as dimethylphenacyl sulfonium, phenacyltetrahydrothiophenium, dimethylbenzyl sulfonium, benzyltetrahydrothiophenium, and octadecylmethylphenacyl sulfonium.

In the case where the cationically polymerizable compound used as the component (C) contains a sulfonium salt, favorable counter anions to adopt to form the sulfonium salt include borate ions, phosphate ions, and gallate ions. Here, a borate ion is a complex ion having boron as the central atom, and a phosphate ion is a complex ion having phosphorus as the central atom. A gallate ion is a complex ion having gallium as the central atom.

Examples of favorable borate ions include, but not limited to, pentafluorophenyl borate, trifluorophenyl borate, tetrafluorophenyl borate, trifluoromethylphenyl borate, bis(trifluoromethyl)phenyl borate, pentafluoroethylphenyl borate, bis(pentafluoroethyl)phenyl borate, fluoro-bis(trifluoromethyl)phenyl borate, fluoro-pentafluoroethylphenyl borate, and fluoro-bis(pentafluoroethyl)phenyl borate.

Examples of favorable phosphate ions include, but not limited to, hexafluorophosphate and tris(pentafluoroethyl)trifluorophosphate.

Examples of favorable gallate ions include, but not limited to, tetrakis(pentafluorophenyl) gallate and tetrakis(3,5-bis(trifluoromethyl)phenyl) gallate.

The component (C) preferably accounts for 0.1 mass% or more, more preferably 0.5 mass% or more, relative to the total amount, which accounts for 100%, of the resin composition. This allows the cationically polymerizable compound to show a sufficiently high curability to ensure an increased patternability. On the other hand, from the viewpoint of ensuring improved storage stability of the resin composition, the component (C) preferably accounts for 10 mass% or less, more preferably 8 mass% or less.

### <Other components>

The negative type photosensitive resin composition according to the present invention may include a photosensitizer. A photosensitizer is a compound that absorbs light and gives the absorbed light energy to the component (C), thereby generating acid to cause cationic polymerization. Furthermore, since the photosensitizer absorbs light in the irradiation wavelength range used in the patterning step, it serves to enable the production of the undermentioned negative type photosensitive resin composition layer with a reduced transmittance from the negative type photosensitive resin composition. Accordingly, the transmittance of the intended negative type photosensitive resin composition layer can be controlled as desired by adjusting the content of the photosensitizer in the negative type photosensitive resin composition.

The photosensitizer to use is not particularly limited, but the use of an anthracene compound is preferable, and it is more preferable to use, for example, an anthracene compound having alkoxy groups at the 9- and 10-positions (9,10-dialkoxy-anthracene derivative). Examples of favorable alkoxy groups include those alkoxy groups that have 1 to 4 carbon atoms such as methoxy group, ethoxy group, and propoxy group. The 9,10-dialkoxy-anthracene derivative may further contain substituent groups. Examples of favorable substituent groups include halogen atoms such as fluorine atom, chlorine atom, bromine atom, and iodine atom; alkyl groups containing 1 to 4 carbon atoms such as methyl group, ethyl group, and propyl group; and others such as sulfonic acid alkyl ester groups and carboxylic acid alkyl ester groups. Examples of favorable alkyl groups present in the sulfonic acid alkyl ester groups or carboxylic acid alkyl ester groups include those alkyl groups containing 1 to 4 carbon atoms such as methyl, ethyl, and propyl. It is preferable for these substituent groups to be located at the 2-position.

The content of the photosensitizer to use is not particularly limited, but it is preferably 0.05 mass% or more, more preferably 0.1 mass% or more, relative to the total amount, which accounts for 100 mass%, of the negative type photosensitive resin composition. This enables the formation of a negative type photosensitive resin composition layer having a reduced transmittance, and even in the case of a substrate having a rough surface, such as a ceramic substrate, reflection from the substrate surface can be suppressed to facilitate the implementation of fine patterning. On the other hand, from the viewpoint of preventing the negative type photosensitive resin composition from forming a negative type photosensitive resin composition layer that gives a cured layer with poor mechanical properties or thermal properties, it is preferable for the content of the photosensitizer to be 10 mass% or less, more preferably 5 mass% or less, relative to the total amount, which accounts for 100 mass%, of the negative type photosensitive resin composition.

The negative type photosensitive resin composition according to the present invention may include a thermal crosslinking agent, and such a thermal crosslinking agent is preferably a compound having an alkoxymethyl group or a methylol group.

Examples of favorable compounds having an alkoxymethyl group or a methylol group include DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP,

HMOM-TPPHBA, and HMOM-TPHAP (all trade names, manufactured by Honshu Chemical Industry Co., Ltd.), and NIKALAC (registered trademark) MX-290, NIKALAC MX-280, NIKALAC MW-100LM, and NIKALAC MX-750LM (all trade names, manufactured by Sanwa Chemical Co., Ltd.).

The negative type photosensitive resin composition according to the present invention may further include a silane compound. The inclusion of a silane compound serves to improve the adhesion of the negative type photosensitive resin composition layer that will be described later. Specific examples of favorable silane compounds include N-phenylaminoethyl trimethoxysilane, N-phenylaminoethyl triethoxysilane, N-phenylaminopropyl trimethoxysilane, N-phenylaminopropyl triethoxysilane, N-phenylaminobutyl trimethoxysilane, N-phenylaminobutyl triethoxysilane, vinyl trimethoxysilane, vinyl triethoxysilane, vinyl trichlorosilane, vinyl tris-(β-methoxyethoxy)silane, 3-methacryloxypropyl trimethoxysilane, 3-acryloxypropyl trimethoxysilane, p-styryl trimethoxysilane, 3-methacryloxypropylmethyl dimethoxysilane, 3-methacryloxypropylmethyl diethoxysilane, and 2-(3,4-epoxycyclohexylethyl trimethoxysilane.

In addition, the negative type photosensitive resin composition according to the present invention may contain a surfactant, an ester such as ethyl lactate and propylene glycol monomethylether acetate, an alcohol such as ethanol, a ketone such as cyclohexanone and methylisobutyl ketone, and an ether such as tetrahydrofuran and dioxane, as required for the purpose of improving the wetting on the support. In addition, for purposes such as achieving a smaller coefficient of thermal expansion, a higher dielectric constant, or a lower dielectric constant, inorganic particles such as those of silicon dioxide or titanium dioxide, powder of polyimide, or the like may also be contained.

### <Negative type photosensitive resin composition layer, negative type photosensitive resin composition film>

The shape of the negative type photosensitive resin composition according to the present invention before curing is not particularly limited, and for example, it may be in the form of varnish, film, etc. The negative type photosensitive resin composition layer according to the present invention is formed from the negative type photosensitive resin composition according to the present invention.

The negative type photosensitive resin composition film according to the present invention includes the negative type photosensitive resin composition according to the present invention processed into a film-like shape and laminated on a support and therefore, it is a negative type photosensitive resin composition film including a negative type photosensitive resin composition layer formed from the negative type photosensitive resin composition according to the present invention and a support. When it is to be used in the form of varnish, it can be produced by dissolving the components (A) to (C) specified previously and other components as required in an organic solvent. Alternatively, the negative type photosensitive resin composition film according to the present invention can also be produced by, for example, spreading the negative type photosensitive resin composition according to the present invention over a support and then drying it as required.

The negative type photosensitive resin composition layer according to the present invention is preferably 5 µm or more in thickness from the viewpoint of handleability. Furthermore, in the case of producing a semiconductor device having the cured layer according to the present invention that will be described later, the thickness is more preferably 20 µm or more, and particularly preferably 30 µm or more, from the viewpoint of facilitating the production of a thick layer. On the other hand, from the viewpoint of suppressing the unevenness in the layer thickness, the thickness of the negative type photosensitive resin composition layer is preferably 100 µm or less, more preferably 80 µm or less, and particularly preferably 60 µm or less.

Next, methods for preparing the negative type photosensitive resin composition film from the negative type photosensitive resin composition according to the present invention are described below. The negative type photosensitive resin composition film according to the present invention can be produced by spreading a solution (varnish) of the negative type photosensitive resin composition over a support and then drying it as required. The negative type photosensitive resin composition varnish (the negative type photosensitive resin composition varnish means the negative type photosensitive resin composition according to the present invention in the form of varnish) can be formed by adding an organic solvent to the negative type photosensitive resin composition. The organic solvent to use here is not particularly limited as long as it can dissolve the negative type photosensitive resin composition.

Specific examples of favorable organic solvents include ethers such as ethylene glycol monomethyl ether, ethylene glycol monoethyl ether, propylene glycol monomethyl ether, propylene glycol monoethyl ether, ethylene glycol dimethyl ether, ethylene glycol diethyl ether, and ethylene glycol dibutyl ether; acetates such as ethylene glycol monoethyl ether acetate, propylene glycol monomethyl ether acetate, propyl acetate, butyl acetate, isobutyl acetate, 3-methoxybutyl acetate, 3-methyl-3-methoxybutyl acetate, methyl lactate, ethyl lactate, and butyl lactate; ketones such as acetone, methyl ethyl ketone, acetyl acetone, methylpropyl ketone, methylbutyl ketone, methylisobutyl ketone, cyclopentanone, and 2-heptanone; alcohols such as butyl alcohol, isobutyl alcohol, pentanol, 4-methyl-2-pentanol, 3-methyl-2-butanol, 3-methyl-3-methoxybutanol, and diacetone alcohol; aromatic hydrocarbons such as toluene and xylene; and others such as N-methyl-2-pyrrolidone, N-cyclohexyl-2-pyrrolidone, N,N-dimethyl formamide, N,N-dimethyl acetamide, dimethyl sulfoxide, and γ-butyrolactone.

Furthermore, the negative type photosensitive resin composition varnish may be filtrated through a filter paper or other filters. The filtering method to use is not particularly limited, but it is preferable to perform filtration under pressure using a filter with a particle retention diameter of 0.4 µm to 10 µm.

The negative type photosensitive resin composition film according to the present invention is spread over a support when in practical use. The support to use is not particularly limited, and various useful films are commercially available including polyethylene terephthalate (PET) films, polyphenylene sulfide films, and polyimide films. The surface of the support to be adhered to the negative type photosensitive resin composition film may be surface-treated with silicone, silane coupling agent, aluminum chelating agent, polyurea, or the like in order to ensure good contact and easy peeling. Furthermore, although the thickness of the support is not particularly limited, it is preferably in the range of 10 to 100 µm from the viewpoint of workability.

In addition, to protect its surface, the negative type photosensitive resin composition film according to the present invention may have a protection film on the film surface. This serves to protect the surface of the negative type photosensitive resin composition film from contaminants such as dirt and dust in the air. Examples of such a protection film include polyolefin film and polyester film. It is preferable for such a protection film to be small in adhesiveness to the negative type photosensitive resin composition film.

Good methods to use to spread the negative type photosensitive resin composition varnish over a support include spin coating using a spinner, spray coating, roll coating, screen printing, and coating techniques using a blade coater, die coater, calender coater, meniscus coater, bar coater, roll coater, comma roll coater, gravure coater, screen coater, slit die coater, or the like. Furthermore, although the required coating thickness varies depending on the coating technique used, the solid content and viscosity of the composition, and the like, it is commonly preferable for the resulting dried coat to have a thickness of 0.5 µm or more and 100 µm or less.

Drying can be carried out by using an oven, hot plate, infrared light, or the like. The drying temperature and drying time period may be set as desired as long as the organic solvent can be volatilized, but it is preferable to set them in appropriate ranges so as to bring the negative type photosensitive resin composition film into an uncured or semicured state. Specifically, it is preferable to maintain a temperature in the range of 40°C to 120°C for 1 minute to several tens of minutes. It may also be good to adopt a combination of different temperatures in this range to perform heating in stages. For example, heat treatment may be performed at 70°C, 80°C, and 90°C for 1 minute at each temperature.

### <Cured layer, semiconductor device>

Next, patterning methods to use for the negative type photosensitive resin composition varnish or for the negative type photosensitive resin composition film formed therefrom and methods to use for their thermocompression bonding to other members will be described with reference to examples.

Described first are methods to form a negative type photosensitive resin composition layer on a substrate using the negative type photosensitive resin composition according to the present invention or the negative type photosensitive resin composition film formed therefrom.

When the negative type photosensitive resin composition varnish is used, the varnish is spread over a substrate first. Useful coating methods include spin coating using a spinner, spray coating, roll coating, and screen printing. Furthermore, although the required coating thickness varies depending on the coating technique used, the solid content and viscosity of the negative type photosensitive resin composition, and the like, it is commonly preferable for the varnish to be applied so that its thickness after drying is to be 0.5 µm or more and 100 µm or less. Next, the substrate coated with the negative type photosensitive resin composition varnish is dried to form a negative type photosensitive resin composition layer. Drying can be carried out by using an oven, hot plate, infrared ray, or the like. The drying temperature and drying time period may be set as desired as long as the organic solvent can be volatilized, but it is preferable to set them in appropriate ranges so as to bring the negative type photosensitive resin composition coat layer into an uncured or semicured state. Specifically, it is preferable to maintain a temperature in the range of 50°C to 150°C for 1 minute to several hours.

On the other hand, in the case where the negative type photosensitive resin composition film is used, the protection film, if any, is peeled off first, and then the negative type photosensitive resin composition film and the substrate are disposed in such a manner that they face each other, followed by combining them by thermocompression bonding to form a negative type photosensitive resin composition layer. Thermocompression bonding can be carried out by hot pressing treatment, thermal lamination treatment, thermal vacuum lamination treatment, or the like. The temperature in the combining step is preferably 40°C or more from the viewpoint of the adhesiveness to the substrate and embedding properties. On the other hand, the temperature in the combining step is preferably 150°C or less in order to prevent the negative type photosensitive resin composition film from being cured during the combining step to cause a decrease in resolution for pattern formation in the light irradiation and development steps.

In any case, useful materials for such a substrate include silicon wafers, various ceramic substrates, gallium arsenide substrate, organic material based circuit boards, inorganic material based circuit boards, and such boards provided with circuit components arranged thereon, although the substrate is not limited thereto. Examples of organic material based circuit boards include laminates of glass base and copper clad such as glass cloth/epoxy-copper clad laminates, composite copper clad laminates such as glass nonwoven fabric/epoxy-copper clad laminates, heat resistant thermoplastic substrates such as polyetherimide resin substrates, polyetherketone resin substrates, and polysulfone based resin substrates, and flexible substrates such as polyester-copper clad film substrates and polyimide-copper clad film substrates. On the other hand, examples of inorganic material based circuit boards include ceramic substrates such as alumina substrates, aluminum nitride substrates, and silicon carbide substrates, and metal base substrates such as aluminum base substrates and iron base substrates. Examples of materials to use for producing circuit components include conductors containing metals such as silver, gold, and copper, resistors containing inorganic oxides, etc., low dielectric materials containing glass based materials and/or resins, high dielectric materials containing resins, high dielectric inorganic particles, etc., and insulators containing glass based materials etc.

Then, an actinic ray is applied to the negative type photosensitive resin composition layer formed by a method as described above through a mask having a desired pattern to carry out light exposure. There are various useful actinic rays for light exposure including ultraviolet ray, visible light, electron beam, and X-ray, but the use of i-line (365 nm), h-line (405 nm), or g-line (436 nm) of a mercury lamp is preferable for the present invention. **In** the case where the negative type photosensitive resin composition film in use has a support that is transparent to these rays, light exposure may be carried out without peeling off the support from the negative type photosensitive resin composition film.

To produce a pattern, the light exposure step is followed by removing the unexposed portion using a developer solution. Preferable developer solutions include aqueous solutions of tetramethyl ammonium hydroxide and aqueous solutions of alkaline compounds such as diethanolamine, diethyl aminoethanol, sodium hydroxide, potassium hydroxide, sodium carbonate, potassium carbonate, triethyl amine, diethyl amine, methyl amine, dimethyl amine, dimethylaminoethyl acetate, dimethylaminoethanol, dimethylaminoethyl methacrylate, cyclohexyl amine, ethylene diamine, and hexamethylene diamine. In some cases, these aqueous alkali solutions may contain polar solvents such as N-methyl-2-pyrrolidone, N,N-dimethylformamide, N,N-dimethylacetamide, dimethyl sulfoxide, γ-butyrolactone, and dimethylacrylamide; alcohols such as methanol, ethanol, and isopropanol; esters such as ethyl lactate and propylene glycol monomethyl ether acetate; and ketones such as cyclopentanone, cyclohexanone, isobutyl ketone, and methylisobutyl ketone; which may be contained singly or as a combination of several ones thereof.

Development can be carried out by spraying a developer solution as described above on the coat surface, covering the entire coat surface with a developer solution, immersing it in a developer solution, or applying supersonic waves to the immersed surface. The development conditions such as development time and the temperature of the developer solution used in the development step may be set up as desired as long as the unexposed portions are removed to realize pattern formation.

Rinsing with water is preferably performed after the development step. Here again, rinsing may be performed with a solution prepared by adding to water an alcohol such as ethanol and isopropyl alcohol or an ester such as ethyl lactate and propylene glycol monomethyl ether acetate.

Furthermore, baking may be performed as required before the development step. In some cases, this can serve to form a pattern with an increased post-development resolution and widen the tolerance range of the development conditions. It is preferable for this baking treatment to be performed in the temperature range of 50°C to 180°C, more preferably 60 °C to 120°C in particular. The treatment time is preferably 5 seconds to several hours.

After the pattern formation step, unreacted molecules of the cationically polymerizable compound and photocationic polymerization initiator are likely to remain in the negative type photosensitive resin composition layer. Accordingly, these are likely to be thermally decomposed during thermocompression bonding or curing to generate gas. To avoid this, it is preferable to irradiate the entire surface of the negative type photosensitive resin composition layer with the aforementioned exposure light after the pattern formation step to ensure that acid is released completely from the photocationic polymerization initiator. By doing so, the reaction of the unreacted molecules of the cationically polymerizable compound proceeds during thermocompression bonding or curing, thereby suppressing the generation of gas attributable to thermal decomposition.

After the development step, heating is performed at a temperature of 150°C to 500°C to cause a thermal crosslinking reaction. This crosslinking serves to realize an increase in heat resistance and chemical resistance. This heat treatment may be performed by any of appropriate methods such as stepwise heating at selected temperatures and continuous heating-up for 5 minutes to 5 hours over an appropriately selected temperature range. As an example of the former method, heat treatment is performed at 130°C and 200°C for 30 minutes at each temperature. As an example of the latter method, heating may be performed for 2 hours in such a manner that the temperature is increased linearly from room temperature to 400°C.

In regard to the cured layer according to the present invention, the negative type photosensitive resin composition according to the present invention or the negative type photosensitive resin composition layer according to the present invention is cured to form the cured layer. The cured layer according to the present invention formed by curing the negative type photosensitive resin composition according to the present invention or the negative type photosensitive resin composition layer present in the negative type photosensitive resin composition film according to the present invention can be used for producing electronic components of semiconductor devices etc.

The semiconductor devices according to the present invention are semiconductor devices that include the cured layer according to the present invention. Here, the term "semiconductor devices" refers collectively to those devices that can function by making use of characteristics of semiconductor elements. Any of electrooptical devices and semiconductor circuit boards containing semiconductor elements and substrates connected to each other, structures containing multiple semiconductor elements laid one on another, and electronic devices incorporating these can all be referred to as semiconductor devices. In addition, electronic components such as multilayer printed circuit boards used to connect semiconductor elements are also included in the category of semiconductor devices. Specifically, suitable applications include interlaminar insulation film in inductors, passivation films of semiconductors, surface protection films of semiconductor elements, interlaminar insulation films between semiconductor elements and wirings, interlaminar insulation films between multiple semiconductor elements, interlaminar insulation films between wiring layers for densely mounted multilayer interconnection, insulation layers of organic electroluminescent devices, interlaminar insulation films of probe cards, interlaminar insulation films of magnetic sensors, and structural members of wavelength selection filters. However, the applications of the present invention are not limited to these, and it can be useful in a wide variety of other applications.

Furthermore, the negative type photosensitive resin composition according to the present invention is characterized in that organic deposits are not generated even when its processing is performed on a substrate having aluminum pad electrodes, and accordingly, it is preferable that the semiconductor devices according to the present invention includes aluminum pad electrodes. As described above, the content of fluorine atoms in the component (A) of the negative type photosensitive resin composition according to the present invention is 1 mass% or less, and this serves to prevent organic deposits from being formed as a result of a reaction between a fluorine-containing gas used for dry etching and the organic components present in the negative type photosensitive resin composition according to the present invention. This means that the use of the negative type photosensitive resin composition according to the present invention serves to produce highly reliable semiconductor devices having organic insulating films even in the case of semiconductor devices having aluminum pad electrodes.

Examples of semiconductor devices having aluminum pad electrodes include, but not limited to, semiconductor packages, densely mounted multilayer wiring boards, probe cards, magnetic sensors, inductors, and wavelength selection filters.

### EXAMPLES

The present invention will be illustrated in detail below with reference to examples, though the invention is not limited thereto.

### <Calculation of content of fluorine atoms in the component (A)>

The component (A) prepared in each synthesis example described later was examined, and the fluorine atom content of the component (A) was calculated from the fluorine atom content of the raw materials used for the synthesis.

### <Patterning on silicon substrate having aluminum pad electrodes>

The protection film was peeled off from the negative type photosensitive resin composition film prepared in each of the Examples and Comparative examples described later, and the exposed surface was laminated onto a 5 cm × 5 cm silicon substrate having aluminum pad electrodes using a vacuum diaphragm type laminator (MVLP-500/600, manufactured by Meiki Co., Ltd.) under the lamination conditions of an upper and lower hot plate temperature of 80°C, a vacuuming time of 20 seconds, a vacuum press time of 30 seconds, and a lamination pressure of 0.5 MPa, thereby forming a resin composition layer with a film thickness of 40 µm on the silicon substrate.

Subsequently, after removing the support film, a mask having a pattern with via sizes of 100 µm, 80 µm, 60 µm, 50 µm, 40 µm, 30 µm, 20 µm, and 10 µm in diameter was set on a light exposure apparatus in such a manner that the opening of each via overlapped with both a aluminum pad electrode portion and a silicon portion. Light exposure was performed using an ultra-high pressure mercury lamp and an i-line bandpass filter under the condition of an exposure gap of 100 µm between the mask and the photosensitive resin composition film. After the light exposure step, post-exposure heating was carried out at 120°C for 10 minutes using a hot plate. Subsequently, using a 2.38 mass% aqueous solution of tetramethyl ammonium hydroxide, dipping development was performed to remove the unexposed regions, followed by rinsing with water. The development time used was twice the time period required for complete dissolution of the unexposed portions. In the case of a negative type photosensitive resin composition layer sample that was not dissolvable in the alkaline developer solution, development was carried out by the same procedure as described above using propylene glycol monomethyl ether acetate (hereinafter referred to as PGMEA) as developing solution and isopropyl alcohol (hereinafter referred to as IPA) as rinsing solution. Then, in an N₂ atmosphere (with an oxygen concentration of 20 ppm or less) in an inert oven (INL-60, manufactured by Koyo Thermo Systems Co., Ltd.), the temperature was raised from room temperature to 200°C over 60 minutes and then the film was heat-treated at 200°C for 60 minutes, thereby forming a patterned cured layer of the negative type photosensitive resin composition film on a silicon substrate having aluminum pad electrodes.

The pattern formed in this way was observed under an optical microscope. The minimum exposure dose required for pattern formation was defined as sensitivity while the minimum size where the resulting pattern is free of any defects such as distortion or blockage was defined as resolution.

Then, the substrate carrying the patterned cured layer was subjected to etching treatment using an etching device. A mixed gas consisting of oxygen and tetrafluoromethane in a volume percent ratio of 20:80 was supplied at a flow rate of 25 sccm, and etching was carried out for 7 minutes under the conditions of a power output of 100 W and a process pressure of 10 Pa.

The pattern resulting from the etching step was observed under an optical microscope to determine the presence or absence of organic deposits around the 100 µm opening in the aluminum pad electrode portion.

The compounds used in each Examples or Comparative example were synthesized by the procedures described below.

### Synthesis example 1: Synthesis of diamine compound (a) free of fluorine atoms

First, 19.0 g (0.05 mole) of 9,9-bis(3-amino-4-hydroxyphenyl) fluorene (hereinafter referred to as FDA) was dissolved in 100 mL of acetone and 17.4 g (0.3 mole) of propylene oxide. To the resulting liquid, a solution of 20.4 g (0.11 mole) of 3-nitrobenzoyl chloride dissolved in 100 mL of acetone was added dropwise. After the end of dropwise addition, the liquid was allowed to react for 4 hours at room temperature, and the resulting white solid precipitate was separated out by filtration and vacuum-dried at 50°C.

A 30 g portion of the solid material was put in a 300 mL stainless steel autoclave and dispersed in 250 mL of methyl cellosolve, followed by adding 2 g of 5% palladium-carbon. Hydrogen was introduced into this liquid using a balloon to cause a reduction reaction at room temperature. About 2 hours later, the reaction was terminated after confirming that the balloon would deflate no more. After the end of the reaction, the liquid was filtrated to remove the palladium compound used as catalyst and concentrated in a rotary evaporator to provide a diamine compound (a) free of fluorine atoms as represented by the formula given below.

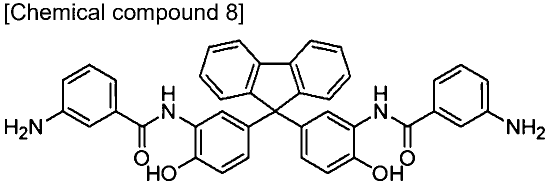

### Synthesis example 2: Synthesis of diamine compound (b) containing fluorine atoms

Except that 2,2-bis(3-amino-4-hydroxyphenyl) hexafluoropropane (hereinafter referred to as BAHF) (18.3 g, 0.05 mole) was used in place of FDA, the same procedure as in Synthesis example 1 was carried out to produce a diamine compound (b) containing fluorine atoms and amide groups as represented by the formula given below.

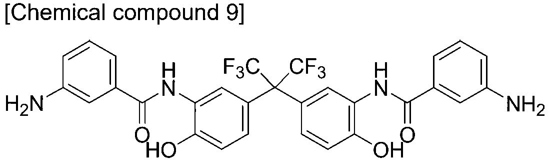

### Synthesis example 3: Synthesis of polyimide (A-1) free of fluorine atoms

In a dry nitrogen flow, 1,3-bis(3-aminophenoxy) benzene (hereinafter referred to as APB-N) (26.31 g, 0.09 mole) was added to 80 g of γ-butyrolactone (hereinafter referred to as GBL) and stirred at 120°C to ensure dissolution. Then, 4-(2,5-dioxotetrahydrofuran-3-yl)-1,2,3,4-tetrahydronaphthalene-1,2-dicarboxylic dianhydride (hereinafter referred to as TDA-100) (30.03 g, 0.1 mole) was added along with 20 g of GBL and the mixture was stirred at 120°C for 1 hour and then stirred at 200°C for 4 hours to provide a reaction solution. Then, the reaction solution was poured in 3 L of water and the resulting white precipitate was collected. This precipitate was collected by filtration, rinsed with water three times, and dried in a vacuum dryer at 80°C for 5 hours to provide a polyimide (A-1).

### Synthesis example 4: Synthesis of polyimide (A-2) containing 0.60 mass% fluorine atoms

Except that the diamine compound (b) containing fluorine atoms (1.81 g, 0.003 mole) and APB-N (25.43 g, 0.087 mole) were used in place of APB-N (26.31 g, 0.09 mole), the same procedure as in Synthesis example 2 was carried out to produce a polyimide (A-2) containing 0.60 mass% fluorine atoms.

### Synthesis example 5: Synthesis of polyamide-imide (A-3) free of fluorine atoms

Except that the diamine compound (a) free of fluorine atoms (55.68 g, 0.09 mole) was used in place of APB-N (26.31 g, 0.09 mole), the same procedure as in Synthesis example 3 was carried out to produce a polyamide-imide (A-3) free of fluorine atoms.

### Synthesis example 6: Synthesis of polyimide (A-4) free of fluorine atoms

Except that 2,2-bis(3-amino-4-hydroxyphenyl) propane (hereinafter referred to as BAP) (23.25 g, 0.09 mole) was used in place of APB-N (26.31 g, 0.09 mole), the same procedure as in Synthesis example 3 was carried out to produce a polyimide (A-4) free of fluorine atoms.

### Synthesis example 7: Synthesis of polyimide (A-5) free of fluorine atoms

Except that bis(3-amino-4-hydroxyphenyl) sulfone (hereinafter referred to as ABPS) (25.23 g, 0.09 mole) was used in place of APB-N (26.31 g, 0.09 mole), the same procedure as in Synthesis example 3 was carried out to produce a polyimide (A-5) free of fluorine atoms.

### Synthesis example 8: Synthesis of polyimide (A-6) free of fluorine atoms

Except that FDA (34.24 g, 0.09 mole) was used in place of APB-N (26.31 g, 0.09 mole), the same procedure as in Synthesis example 3 was carried out to produce a polyimide (A-6) free of fluorine atoms.

### Synthesis example 9: Synthesis of polyimide (A-7) free of fluorine atoms

Except that 1,3-bis(4-amino-3-hydroxyphoxy) benzene (hereinafter referred to as AHPB) (29.19 g, 0.09 mole) was used in place of APB-N (26.31 g, 0.09 mole), the same procedure as in Synthesis example 3 was carried out to produce a polyimide (A-7) free of fluorine atoms.

### Synthesis example 10: Synthesis of polyimide (A-8) free of fluorine atoms

Except that BAP (15.50 g, 0.06 mole) and APB-N (8.77 g, 0.03 mole) were used in place of APB-N (26.31 g, 0.09 mole), the same procedure as in Synthesis example 3 was carried out to produce a polyimide (A-8) free of fluorine atoms.

### Synthesis example 11: Synthesis of polyimide (A-9) free of fluorine atoms

Except that BAP (7.75 g, 0.03 mole) and APB-N (17.54 g, 0.06 mole) were used in place of APB-N (26.31 g, 0.09 mole), the same procedure as in Synthesis example 3 was carried out to produce a polyimide (A-9) free of fluorine atoms.

### Synthesis example 12: Synthesis of polyimide (A-10) free of fluorine atoms

Except that APBS (16.82 g, 0.06 mole) and APB-N (8.77 g, 0.03 mole) were used in place of APB-N (26.31 g, 0.09 mole), the same procedure as in Synthesis example 3 was carried out to produce a polyimide (A-10) free of fluorine atoms.

### Synthesis example 13: Synthesis of polyimide (A-11) free of fluorine atoms

Except that APBS (8.41 g, 0.03 mole) and APB-N (17.54 g, 0.06 mole) were used in place of APB-N (26.31 g, 0.09 mole), the same procedure as in Synthesis example 3 was carried out to produce a polyimide (A-11) free of fluorine atoms.

### Synthesis example 14: Synthesis of polyimide (A-12) free of fluorine atoms

Except that FDA (30.44 g, 0.08 mole) and APB-N (2.92 g, 0.01 mole) were used in place of APB-N (26.31 g, 0.09 mole), the same procedure as in Synthesis example 3 was carried out to produce a polyimide (A-12) free of fluorine atoms.

### Synthesis example 15: Synthesis of polyimide (A-13) free of fluorine atoms

Except that FDA (22.83 g, 0.06 mole) and APB-N (8.77 g, 0.03 mole) were used in place of APB-N (26.31 g, 0.09 mole), the same procedure as in Synthesis example 3 was carried out to produce a polyimide (A-13) free of fluorine atoms.

### Synthesis example 16: Synthesis of polyimide (A-14) free of fluorine atoms

Except that FDA (11.41 g, 0.03 mole) and APB-N (17.54 g, 0.06 mole) were used in place of APB-N (26.31 g, 0.09 mole), the same procedure as in Synthesis example 3 was carried out to produce a polyimide (A-14) free of fluorine atoms.

### Synthesis example 17: Synthesis of polyimide (A-15) free of fluorine atoms

Except that AHPB (25.95 g, 0.08 mole) and APB-N (2.92 g, 0.01 mole) were used in place of APB-N (26.31 g, 0.09 mole), the same procedure as in Synthesis example 3 was carried out to produce a polyimide (A-15) free of fluorine atoms.

### Synthesis example 18: Synthesis of polyimide (A-16) free of fluorine atoms

Except that AHPB (19.46 g, 0.06 mole) and APB-N (8.77 g, 0.03 mole) were used in place of APB-N (26.31 g, 0.09 mole), the same procedure as in Synthesis example 3 was carried out to produce a polyimide (A-16) free of fluorine atoms.

### Synthesis example 19: Synthesis of polyimide (A-17) free of fluorine atoms

Except that AHPB (9.73 g, 0.06 mole) and APB-N (8.77 g, 0.03 mole) were used in place of APB-N (26.31 g, 0.09 mole), the same procedure as in Synthesis example 3 was carried out to produce a polyimide (A-17) free of fluorine atoms.

### Synthesis example 20: Synthesis of polyimide (A-18) free of fluorine atoms

Except that BAP (23.25 g, 0.09 mole) was used in place of APB-N (26.31 g, 0.09 mole) and that 4,4'-oxydiphthalic anhydride (hereinafter referred to as ODPA) (31.02 g, 0.1 mole) was used in place of TDA-100 (30.03 g, 0.1 mole), the same procedure as in Synthesis example 3 was carried out to produce a polyimide (A-18) free of fluorine atoms.

### Synthesis example 21: Synthesis of polyimide (A-19) free of fluorine atoms

Except that ABPS (25.23 g, 0.09 mole) was used in place of APB-N (26.31 g, 0.09 mole) and that ODPA (31.02 g, 0.1 mole) was used in place of TDA-100 (30.03 g, 0.1 mole), the same procedure as in Synthesis example 3 was carried out to produce a polyimide (A-19) free of fluorine atoms.

### Synthesis example 22: Synthesis of polyimide (A-20) free of fluorine atoms

Except that FDA (34.24 g, 0.09 mole) was used in place of APB-N (26.31 g, 0.09 mole) and that ODPA (31.02 g, 0.1 mole) was used in place of TDA-100 (30.03 g, 0.1 mole), the same procedure as in Synthesis example 3 was carried out to produce a polyimide (A-20) free of fluorine atoms.

### Synthesis example 23: Synthesis of polyimide (A-21) free of fluorine atoms

Except that AHPB (29.19 g, 0.09 mole) was used in place of APB-N (26.31 g, 0.09 mole) and that ODPA (31.02 g, 0.1 mole) was used in place of TDA-100 (30.03 g, 0.1 mole), the same procedure as in Synthesis example 3 was carried out to produce a polyimide (A-21) free of fluorine atoms.

### Synthesis example 24: Synthesis of polyimide (A-22) free of fluorine atoms

Except that BAP (23.25 g, 0.09 mole) was used in place of APB-N (26.31 g, 0.09 mole) and that dicyclohexyl-3,4,3',4'-tetracarboxylic dianhydride (hereinafter referred to as HBPDA) (30.63 g, 0.1 mole) was used in place of TDA-100 (30.03 g, 0.1 mole), the same procedure as in Synthesis example 3 was carried out to produce a polyimide (A-22) free of fluorine atoms.

### Synthesis example 25: Synthesis of polyimide (A-23) free of fluorine atoms

Except that ABPS (25.23 g, 0.09 mole) was used in place of APB-N (26.31 g, 0.09 mole) and that HBPDA (30.63 g, 0.1 mole) was used in place of TDA-100 (30.03 g, 0.1 mole), the same procedure as in Synthesis example 3 was carried out to produce a polyimide (A-23) free of fluorine atoms.

### Synthesis example 26: Synthesis of polyimide (A-24) free of fluorine atoms

Except that FDA (34.24 g, 0.09 mole) was used in place of APB-N (26.31 g, 0.09 mole) and that HBPDA (30.63 g, 0.1 mole) was used in place of TDA-100 (30.03 g, 0.1 mole), the same procedure as in Synthesis example 3 was carried out to produce a polyimide (A-24) free of fluorine atoms.

### Synthesis example 27: Synthesis of polyimide (A-25) free of fluorine atoms

Except that AHPB (29.19 g, 0.09 mole) was used in place of APB-N (26.31 g, 0.09 mole) and that HBPDA (30.63 g, 0.1 mole) was used in place of TDA-100 (30.03 g, 0.1 mole), the same procedure as in Synthesis example 3 was carried out to produce a polyimide (A-25) free of fluorine atoms.

### Synthesis example 28: Synthesis of polyimide (A-26) free of fluorine atoms

Except that FDA (26.63 g, 0.07 mole) was used in place of APB-N (26.31 g, 0.09 mole), the same procedure as in Synthesis example 3 was carried out to produce a polyimide (A-26) free of fluorine atoms.

### Synthesis example 29: Synthesis of polyimide (A-27) free of fluorine atoms

Except that AHPB (22.70 g, 0.07 mole) was used in place of APB-N (26.31 g, 0.09 mole), the same procedure as in Synthesis example 3 was carried out to produce a polyimide (A-27) free of fluorine atoms.

### Synthesis example 30: Synthesis of polyimide precursor (A-28) free of fluorine atoms

In a dry nitrogen flow, BAP (23.25g, 0.9 mole) was added to 80 g of GBL and stirred at 120°C to ensure dissolution. To this liquid, TDA-100 (30.03 g, 0.1 mole) was added along with 20 g of GBL and stirred at 120°C for 1 hour to provide a reaction solution. Then, the reaction solution was poured into 3 L of water and the resulting white precipitate was collected. This precipitate was collected by filtration, rinsed with water three times, and dried in a vacuum dryer at 80°C for 5 hours to provide a polyimide precursor (A-28).

### Synthesis example 31: Synthesis of polyimide precursor (A-29) free of fluorine atoms

Except that ABPS (25.23 g, 0.09 mole) was used in place of BAP (23.25 g, 0.09 mole), the same procedure as in Synthesis example 30 was carried out to produce a polyimide (A-29) free of fluorine atoms.

### Synthesis example 32: Synthesis of polyimide precursor (A-30) free of fluorine atoms

Except that FDA (34.24 g, 0.09 mole) was used in place of BAP (23.25 g, 0.09 mole), the same procedure as in Synthesis example 30 was carried out to produce a polyimide (A-30) free of fluorine atoms.

### Synthesis example 33: Synthesis of polyimide precursor (A-31) free of fluorine atoms

Except that AHPB (29.19 g, 0.09 mole) was used in place of BAP (23.25 g, 0.09 mole), the same procedure as in Synthesis example 30 was carried out to produce a polyimide (A-31) free of fluorine atoms.

### Synthesis example 34: Synthesis of polyimide (A-32) free of fluorine atoms

Except that 3,5-diaminobenzoic acid (hereinafter referred to as DABA) (13.69 g, 0.09 mole) was used in place of APB-N (26.31 g, 0.09 mole), the same procedure as in Synthesis example 3 was carried out to produce a polyimide (A-32) free of fluorine atoms.

### Synthesis example 35: Synthesis of polyimide (A-33) free of fluorine atoms

Except that DABA (10.65 g, 0.07 mole) and 1,3-bis(3-aminopropyl)-1,1,3,3-tetramethyl disiloxane (hereinafter referred to as SiDA) (4.97 g, 0.02 mole) were used in place of APB-N (26.31 g, 0.09 mole), the same procedure as in Synthesis example 3 was carried out to produce a polyimide (A-33) free of fluorine atoms.

### Synthesis example 36: Synthesis of polyimide (A-34) free of fluorine atoms

Except that DABA (9.13 g, 0.06 mole) and SiDA (7.46 g, 0.03 mole) were used in place of APB-N (26.31 g, 0.09 mole), the same procedure as in Synthesis example 3 was carried out to produce a polyimide (A-34) free of fluorine atoms.

### Synthesis example 37: Synthesis of polyimide (A-35) free of fluorine atoms

Except that DABA (7.61 g, 0.05 mole) and SiDA (9.94 g, 0.04 mole) were used in place of APB-N (26.31 g, 0.09 mole), the same procedure as in Synthesis example 3 was carried out to produce a polyimide (A-35) free of fluorine atoms.

### Synthesis example 38: Synthesis of polyimide (A-36) free of fluorine atoms

Except that DABA (4.56 g, 0.03 mole) and SiDA (14.91 g, 0.06 mole) were used in place of APB-N (26.31 g, 0.09 mole), the same procedure as in Synthesis example 3 was carried out to produce a polyimide (A-36) free of fluorine atoms.

### Synthesis example 39: Synthesis of polyimide (A-37) free of fluorine atoms

Except that DABA (3.04 g, 0.02 mole) and SiDA (17.40 g, 0.07 mole) were used in place of APB-N (26.31 g, 0.09 mole), the same procedure as in Synthesis example 3 was carried out to produce a polyimide (A-37) free of fluorine atoms.

### Synthesis example 40: Synthesis of polyimide (A-38) free of fluorine atoms

Except that FDA (30.44 g, 0.08 mole) and SiDA (2.49 g, 0.01 mole) were used in place of APB-N (26.31 g, 0.09 mole), the same procedure as in Synthesis example 3 was carried out to produce a polyimide (A-38) free of fluorine atoms.

Synthesis example 41: Synthesis of polyimide (A-39) containing 12.15 mass% fluorine atoms Except that the diamine compound (b) containing fluorine atoms (54.41 g, 0.09 mole) was used in place of APB-N (26.31 g, 0.09 mole), the same procedure as in Synthesis example 3 was carried out to produce a polyimide (A-39) containing fluorine atoms.

### Synthesis example 42: Synthesis of polyimide (A-40) containing 12.01 mass% fluorine atoms

Except that the diamine compound (b) containing fluorine atoms (54.41 g, 0.09 mole) was used in place of APB-N (26.31 g, 0.09 mole) and that ODPA (31.02 g, 0.1 mole) was used in place of TDA-100 (30.03 g, 0.1 mole), the same procedure as in Synthesis example 3 was carried out to produce a polyimide (A-40) containing fluorine atoms.

### Synthesis example 43: Synthesis of polyimide (A-41) containing 1.92 mass% fluorine atoms

Except that the diamine compound (b) containing fluorine atoms (6.05 g, 0.01 mole) and APB-N (23.39 g, 0.08 mole) were used in place of APB-N (26.31 g, 0.09 mole), the same procedure as in Synthesis example 3 was carried out to produce a polyimide (A-41) containing 1.92 mass% fluorine atoms.

### Example 1

First, 10 g of the polyimide (A-1) used as component (A), 12 g of TEPIC-VL (trade name, manufactured by Nissan Chemical Corporation) as component (B), 0.6 g of CPI-310B (trade name, manufactured by San Apro Ltd.) as component (C), and 0.4 g of X-12-967C (trade name, manufactured by Shin-Etsu Chemical Co., Ltd.) as a silane coupling agent were dissolved in GBL. The amount of the solvent to be added was adjusted in such a manner that the solid content was 60 mass%, wherein the solid components were the additives other than the solvent. Then, the liquid was subjected to pressure filtration through a filter with a particle retention diameter of 1 µm to provide a negative type photosensitive resin composition varnish.

The resulting negative type photosensitive resin composition varnish was spread over a PET film with a thickness of 50 µm using a comma roll coater and dried at 120°C for 8 minutes, followed laying a 30 µm thick polypropylene (PP) film as protection film to provide a negative type photosensitive resin composition film. The thickness of the negative type photosensitive resin composition film was adjusted to 40 µm. The negative type photosensitive resin composition film thus obtained was subjected to evaluation for patternability on a silicon substrate having aluminum pad electrodes as described above. Results are given in Table 2.

### Examples 2 to 50

Except that the compounds having structures as shown in Table 1 were used as the components (A) to (C) and other components, the same procedure as Example 1 was carried out to produce a negative type photosensitive resin composition film, and it was subjected to evaluation for patternability on a silicon substrate having aluminum pad electrodes as described above. Results are given in Table 2.

### Comparative examples 1 to 3

Except that the compounds having structures as shown in Table 1 were used as the components (A) to (C) and other components, the same procedure as Example 1 was carried out to produce a resin composition film, and it was subjected to evaluation for patternability on a silicon substrate having aluminum pad electrodes as described above. Results are given in Table 2.

**[Table 1-1]**

| Table 1 | | | | | | | | | | | | | |
|---|---|---|---|---|---|---|---|---|---|---|---|---|---|
| | component (A) | | | | | component (B) | | | | component (C) | | silane coupling agent | |
| | name | par ts by wei ght | diami ne resid ue mol% (α) | diami ne resid ue mol% (β) | fluori ne atom conte nt | name | par ts by wei ght | name | par ts by wei ght | name | par ts by wei ght | name | par ts by wei ght |
| Exam ple 1 | A-1 | 10 0 | 0 | 0 | 0.00 % | TEPIC -VL | 12 0 | - | - | CPI-310B | 6 | X-12-967C | 4 |
| Exam ple 2 | A-2 | 10 0 | 0 | 0 | 0.60 % | TEPIC -VL | 12 0 | - | - | CPI-310B | 6 | X-12-967C | 4 |
| Exam ple 3 | A-3 | 10 0 | 100 | 0 | 0.00 % | TEPIC -VL | 12 0 | - | - | CPI-310B | 6 | X-12-967C | 4 |
| Exam ple 4 | A-4 | 10 0 | 100 | 0 | 0.00 % | TEPIC -VL | 12 0 | - | - | CPI-310B | 6 | X-12-967C | 4 |
| Exam ple 5 | A-5 | 10 0 | 100 | 0 | 0.00 % | TEPIC -VL | 12 0 | - | - | CPI-310B | 6 | X-12-967C | 4 |
| Exam ple 6 | A-6 | 10 0 | 100 | 100 | 0.00 % | TEPIC -VL | 12 0 | - | - | CPI-310B | 6 | X-12-967C | 4 |
| Exam ple 7 | A-7 | 10 0 | 100 | 100 | 0.00 % | TEPIC -VL | 12 0 | - | - | CPI-310B | 6 | X-12-967C | 4 |
| Exam ple 8 | A-8 | 10 0 | 66.7 | 0 | 0.00 % | TEPIC -VL | 12 0 | - | - | CPI-310B | 6 | X-12-967C | 4 |
| Exam ple 9 | A-9 | 10 0 | 66.7 | 0 | 0.00 % | TEPIC -VL | 12 0 | - | - | CPI-310B | 6 | X-12-967C | 4 |
| Exam ple 10 | A-10 | 10 0 | 66.7 | 0 | 0.00 % | TEPIC -VL | 12 0 | - | - | CPI-310B | 6 | X-12-967C | 4 |
| Exam ple 11 | A-11 | 10 0 | 66.7 | 0 | 0.00 % | TEPIC -VL | 12 0 | - | - | CPI-310B | 6 | X-12-967C | 4 |
| Exam ple 12 | A-12 | 10 0 | 88.9 | 88.9 | 0.00 % | TEPIC -VL | 12 0 | - | - | CPI-310B | 6 | X-12-967C | 4 |
| Exam ple 13 | A-13 | 10 0 | 66.7 | 66.7 | 0.00 % | TEPIC -VL | 12 0 | - | - | CPI-310B | 6 | X-12-967C | 4 |
| Exam ple 14 | A-14 | 10 0 | 33.3 | 33.3 | 0.00 % | TEPIC -VL | 12 0 | - | - | CPI-310B | 6 | X-12-967C | 4 |
| Exam ple 15 | A-15 | 10 0 | 88.9 | 88.9 | 0.00 % | TEPIC -VL | 12 0 | - | - | CPI-310B | 6 | X-12-967C | 4 |
| Exam ple 16 | A-16 | 10 0 | 66.7 | 66.7 | 0.00 % | TEPIC -VL | 12 0 | - | - | CPI-310B | 6 | X-12-967C | 4 |
| Exam ple 17 | A-17 | 10 0 | 33.3 | 33.3 | 0.00 % | TEPIC -VL | 12 0 | - | - | CPI-310B | 6 | X-12-967C | 4 |
| Exam ple 18 | A-18 | 10 0 | 100 | 0 | 0.00 % | TEPIC -VL | 12 0 | - | - | CPI-310B | 6 | X-12-967C | 4 |
| Exam ple 19 | A-19 | 10 0 | 100 | 0 | 0.00 % | TEPIC -VL | 12 0 | - | - | CPI-310B | 6 | X-12-967C | 4 |
| Exam ple 20 | A-20 | 10 0 | 100 | 100 | 0.00 % | TEPIC -VL | 12 0 | - | - | CPI-310B | 6 | X-12-967C | 4 |

### [Table 1-2]

**Table 1-2**

| | component (A) | | | | | component (B) | | | | component (C) | | silane coupling agent | |
|---|---|---|---|---|---|---|---|---|---|---|---|---|---|
| | nam e | par ts by wei ght | diami ne residu e mol% (α) | diami ne residu e mol% (β) | fluorin e atom conte nt | name | par ts by wei ght | name | par ts by wei ght | name | par ts by wei ght | name | par ts by wei ght |
| Exam ple 21 | A-21 | 10 0 | 100 | 100 | 0.00% | TEPIC-VL | 12 0 | - | - | CPI-310B | 6 | X-12-967C | 4 |
| Exam ple 22 | A-22 | 10 0 | 100 | 0 | 0.00% | TEPIC-VL | 12 0 | - | - | CPI-310B | 6 | X-12-967C | 4 |
| Exam ple 23 | A-23 | 10 0 | 100 | 0 | 0.00% | TEPIC-VL | 12 0 | - | - | CPI-310B | 6 | X-12-967C | 4 |
| Exam ple 24 | A-24 | 10 0 | 100 | 100 | 0.00% | TEPIC-VL | 12 0 | - | - | CPI-310B | 6 | X-12-967C | 4 |
| Exam ple 25 | A-25 | 10 0 | 100 | 100 | 0.00% | TEPIC-VL | 12 0 | - | - | CPI-310B | 6 | X-12-967C | 4 |
| Exam ple 26 | A-26 | 10 0 | 100 | 100 | 0.00% | TEPIC-VL | 12 0 | - | - | CPI-310B | 6 | X-12-967C | 4 |
| Exam ple 27 | A-27 | 10 0 | 100 | 100 | 0.00% | TEPIC-VL | 12 0 | - | - | CPI-310B | 6 | X-12-967C | 4 |
| Exam le 28 | A-28 | 10 0 | 100 | 0 | 0.00% | TEPIC-VL | 12 0 | - | - | CPI-310B | 6 | X-12-967C | 4 |
| Exam le 29 | A-29 | 10 0 | 100 | 0 | 0.00% | TEPIC-VL | 12 0 | - | - | CPI-310B | 6 | X-12-967C | 4 |
| Exam ple 30 | A-30 | 10 0 | 100 | 100 | 0.00% | TEPIC-VL | 12 0 | - | - | CPI-310B | 6 | X-12-967C | 4 |
| Exam ple 31 | A-31 | 10 0 | 100 | 100 | 0.00% | TEPIC-VL | 12 0 | - | - | CPI-310B | 6 | X-12-967C | 4 |
| Exam ple 32 | A-4 | 10 0 | 100 | 0 | 0.00% | TEPIC-VL | 12 0 | - | - | CPI-310FG | 6 | X-12-967C | 4 |
| Exam ple 33 | A-5 | 10 0 | 100 | 0 | 0.00% | TEPIC-VL | 12 0 | - | - | CPI-310FG | 6 | X-12-967C | 4 |
| Exam ple 34 | A-6 | 10 0 | 100 | 100 | 0.00% | TEPIC-VL | 12 0 | - | - | CPI-310FG | 6 | X-12-967C | 4 |
| Exam ple 35 | A-7 | 10 0 | 100 | 100 | 0.00% | TEPIC-VL | 12 0 | - | - | CPI-310FG | 6 | X-12-967C | 4 |
| Exam ple 36 | A-32 | 10 0 | 0 | 0 | 0.00% | TEPIC-VL | 12 0 | - | - | CPI-310B | 6 | X-12-967C | 4 |
| Exam ple 37 | A-33 | 10 0 | 0 | 0 | 0.00% | TEPIC-VL | 12 0 | - | - | CPI-310B | 6 | X-12-967C | 4 |
| Exam ple 38 | A-34 | 10 0 | 0 | 0 | 0.00% | TEPIC-VL | 12 0 | - | - | CPI-310B | 6 | X-12-967C | 4 |
| Exam ple 39 | A-35 | 10 0 | 0 | 0 | 0.00% | TEPIC-VL | 12 0 | - | - | CPI-310B | 6 | X-12-967C | 4 |
| Exam ple 40 | A-36 | 10 0 | 0 | 0 | 0.00% | TEPIC-VL | 12 0 | - | - | CPI-310B | 6 | X-12-967C | 4 |

### [Table 1-3]

**Table 1-3**

| | component (A) | | | | | component (B) | | | | component (C) | | silane coupling agent | |
|---|---|---|---|---|---|---|---|---|---|---|---|---|---|
| | nam e | par ts by we igh t | diami ne resid ue mol% (a) | diami ne resid ue mol% (β) | fluori ne atom conte nt | name | par ts by we igh t | name | par ts by we igh t | name | par ts by we igh t | name | par ts by we igh t |
| Exam ple 41 | A-37 | 10 0 | 0 | 0 | 0.00 % | TEPIC -VL | 12 0 | - | - | CPI-310B | 6 | X-12-967C | 4 |
| Exam ple 42 | A-38 | 10 0 | 88.9 | 88.9 | 0.00 % | TEPIC -VL | 12 0 | - | - | CPI-310B | 6 | X-12-967C | 4 |
| Exam ple 43 | A-26 | 10 0 | 100 | 100 | 0.00 % | PETG | 72 | BATG | 48 | CPI-310B | 6 | X-12-967C | 4 |
| Exam ple 44 | A-26 | 10 0 | 100 | 100 | 0.00 % | YL980 | 12 0 | - | - | CPI-310B | 6 | X-12-967C | 4 |
| Exam ple 45 | A-26 | 10 0 | 100 | 100 | 0.00 % | OXT-121 | 12 0 | | | CPI-310B | 3 | X-12-967C | 4 |
| Exam ple 46 | A-26 | 10 0 | 100 | 100 | 0.00 % | OXBP | 12 0 | - | - | CPI-310B | 3 | X-12-967C | 4 |
| Exam ple 47 | A-26 | 10 0 | 100 | 100 | 0.00 % | OXT-221 | 12 0 | | | CPI-310B | 3 | X-12-967C | 4 |
| Exam ple 48 | A-26 | 10 0 | 100 | 100 | 0.00 % | TEPIC -VL | 60 | OXBP | 60 | CPI-310B | 4 | X-12-967C | 4 |
| Exam ple 49 | A-26 | 10 0 | 100 | 100 | 0.00 % | TEPIC -VL | 60 | - | - | CPI-310B | 6 | X-12-967C | 4 |
| Exam ple 50 | A-26 | 10 0 | 100 | 100 | 0.00 % | TEPIC -VL | 16 0 | - | - | CPI-310B | 6 | X-12-967C | 4 |
| Com parati ve exam ple 1 | A-39 | 10 0 | 0 | 0 | 12.15 % | TEPIC -VL | 12 0 | - | - | CPI-310B | 6 | X-12-967C | 4 |
| Com parati ve exam ple 2 | A-40 | 10 0 | 0 | 0 | 12.01 % | TEPIC -VL | 12 0 | - | - | CPI-310B | 6 | X-12-967C | 4 |
| Com parati ve exam ple 3 | A-41 | 10 0 | 0 | 0 | 1.92 % | TEPIC -VL | 12 0 | - | - | CPI-310B | 6 | X-12-967C | 4 |

### [Table 2-1]

**Table 2-1**

| | developer | sensitivity | resolution | organic deposit |
|---|---|---|---|---|
| Example 1 | PGMEA | 700 | 40 | not formed |
| Example 2 | PGMEA | 700 | 40 | not formed |
| Example 3 | TMAH | 2000 | 60 | not formed |
| Example 4 | TMAH | 1500 | 40 | not formed |
| Example 5 | TMAH | 500 | 40 | not formed |
| Example 6 | TMAH | 700 | 30 | not formed |
| Example 7 | TMAH | 500 | 30 | not formed |
| Example 8 | TMAH | 1000 | 50 | not formed |
| Example 9 | TMAH | 1200 | 60 | not formed |
| Example 10 | TMAH | 600 | 50 | not formed |
| Example 11 | TMAH | 700 | 60 | not formed |
| Example 12 | TMAH | 700 | 40 | not formed |
| Example 13 | TMAH | 800 | 40 | not formed |
| Example 14 | TMAH | 800 | 50 | not formed |
| Example 15 | TMAH | 600 | 40 | not formed |
| Example 16 | TMAH | 700 | 40 | not formed |
| Example 17 | TMAH | 800 | 50 | not formed |
| Example 18 | TMAH | 2500 | 80 | not formed |
| Example 19 | TMAH | 1200 | 80 | not formed |
| Example 20 | TMAH | 1500 | 60 | not formed |

### [Table 2-2]

**Table 2-2**

| | developer | sensitivity | resolution | organic deposit |
|---|---|---|---|---|
| Example 21 | TMAH | 1200 | 50 | not formed |
| Example 22 | TMAH | 1500 | 50 | not formed |
| Example 23 | TMAH | 500 | 50 | not formed |
| Example 24 | TMAH | 700 | 40 | not formed |
| Example 25 | TMAH | 500 | 40 | not formed |
| Example 26 | TMAH | 700 | 20 | not formed |
| Example 27 | TMAH | 500 | 20 | not formed |
| Example 28 | TMAH | 2500 | 40 | not formed |
| Example 29 | TMAH | 2000 | 40 | not formed |
| Example 30 | TMAH | 2000 | 30 | not formed |
| Example 31 | TMAH | 2000 | 30 | not formed |
| Example 32 | TMAH | 1500 | 40 | not formed |
| Example 33 | TMAH | 500 | 40 | not formed |
| Example 34 | TMAH | 700 | 30 | not formed |
| Example 35 | TMAH | 500 | 30 | not formed |
| Example 36 | TMAH | 500 | 60 | not formed |
| Example 37 | TMAH | 500 | 50 | not formed |
| Example 38 | TMAH | 600 | 40 | not formed |
| Example 39 | TMAH | 600 | 30 | not formed |
| Example 40 | TMAH | 600 | 40 | not formed |

### [Table 2-3]

**Table 2-3**

| | developer | sensitivity | resolution | organic deposit |
|---|---|---|---|---|
| Example 41 | TMAH | 600 | 50 | not formed |
| Example 42 | TMAH | 700 | 20 | not formed |
| Example 43 | TMAH | 700 | 20 | not formed |
| Example 44 | TMAH | 800 | 40 | not formed |
| Example 45 | TMAH | 400 | 30 | not formed |
| Example 46 | TMAH | 400 | 30 | not formed |
| Example 47 | TMAH | 400 | 40 | not formed |
| Example 48 | TMAH | 500 | 20 | not formed |
| Example 49 | TMAH | 1000 | 20 | not formed |
| Example 50 | TMAH | 600 | 30 | not formed |
| Comparative example 1 | TMAH | 2000 | 60 | formed |
| Comparative example 2 | TMAH | 2500 | 100 | formed |
| Comparative example 3 | PGMEA | 1000 | 40 | formed |

In Table 1, the column for "diamine residue mol% (α)" shows the total proportion of diamine residues derived from diamines as represented by any of the general formulae (1) to (4) relative to the total amount, which accounts for 100 mol%, of all diamine residues present in the component (A). Compared to this, the column for "diamine residue mol% (β)" in Table 1 shows the total proportion of diamine residues derived from diamines as represented by the general formula (3) or (4) relative to the total amount, which accounts for 100 mol%, of all diamine residues present in the component (A). Furthermore, the column for "fluorine atom content" in Table 1 shows the content of fluorine atoms in the component (A).

It is evident from Table 1 and Table 2 that in Comparative examples 1, 2, and 3, organic deposits were formed when patterning was carried out on a silicon substrate having aluminum pad electrodes.

Compared to this, it is shown that the negative type photosensitive resin composition according to the present invention is high in patternability when having a large thickness and also that organic deposits are not generated even when its processing is performed on a substrate having aluminum pad electrodes.

Furthermore, a comparison between Examples 1 and 2 with Examples 4 to 17 shows that high alkali developability is achieved in addition to the aforementioned good features realized in these Examples when a diamine residue derived from at least one diamine as represented by any of the general formulae (1) to (4) is contained.

It is also seen from a comparison between Example 3 with Examples 4 to 17 that high patternability with high sensitivity or resolution is achieved in addition to the aforementioned good features realized in these Examples when a diamine residue derived from at least one diamine as represented by any of the general formulae (1) to (4) is contained.

Furthermore, a comparison between Examples 1 and 2 with Examples 36 to 41 shows that high alkali developability is achieved in addition to the aforementioned good features realized in these Examples when a diamine residue derived from a diamine as represented by the general formula (5) is contained.

It is also seen from a comparison between Example 3 with Examples 36 to 41 that high patternability with high sensitivity or resolution is achieved in addition to the aforementioned good features realized in these Examples when a diamine residue derived from a diamine as represented by the general formula (5) is contained. Furthermore, a comparison between Examples 4 and 5 with Examples 6 and 7 shows that high patternability with very high resolution is achieved in addition to the aforementioned good features realized in these Examples when the total proportion of diamine residues derived from diamines as represented by the general formula (3) or (4) is 50 to 100 mol% relative to the total amount, which accounts for 100 mol%, of all diamine residues present in the component (A).

The compounds used in each Synthesis example, Example, or Comparative example are listed below.
(A) Compounds used for synthesis of component (A)
   TDA-100: acid dianhydride as represented by the general formula (5)
   ODPA: acid dianhydride
   HBPDA: acid dianhydride having alicyclic structure
   APB-N: diamine free of fluorine atoms
   BAP: diamine as represented by the general formula (1)
   ABPS: diamine as represented by the general formula (2)
   FDA: diamine as represented by the general formula (3)
   AHPB: diamine as represented by the general formula (4)
   DABA: diamine as represented by the general formula (5)
   SiDA: silicone diamine
   diamine compound (a) free of fluorine atoms
   diamine compound (b) containing fluorine atoms 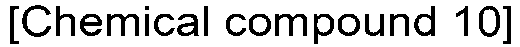 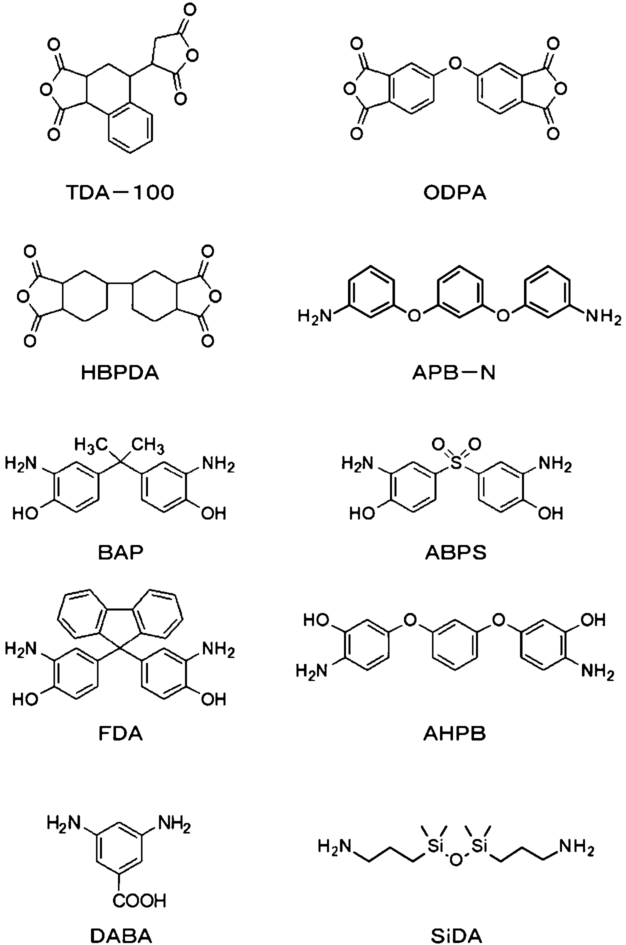 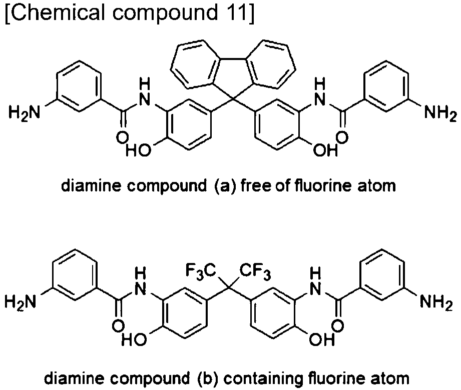
(B) Cationically polymerizable compound
   TEPIC-VL (manufactured by Nissan Chemical Corporation, epoxy compound)
   PETG (manufactured by Resonac Corporation, epoxy compound)
   BATG (manufactured by Resonac Corporation, epoxy compound)
   YL980 (manufactured by Mitsubishi Chemical Corporation, epoxy compound)
   OXT-121 (manufactured by Toagosei Co., Ltd., oxetane compound)
   OXBP (manufactured by UBE Corporation, oxetane compound)
   OXT-221 (manufactured by Toagosei Co., Ltd., oxetane compound)
(C) Photocationic polymerization initiator
   CPI-310B (manufactured by San-Apro Ltd., sulfonium salt containing borate ion)
   CPI-310FG: (manufactured by San-Apro Ltd.) sulfonium salt containing gallate ion)
   Silane coupling agent
   X-12-967C (manufactured by Shin-Etsu Chemical Co., Ltd.)

## Claims

1. A negative type photosensitive resin composition including at least one polymer compound selected from the group consisting of polyamide, polyimide, polyamide-imide, and polybenzoxazole, as a component (A), a cationically polymerizable compound as a component (B), and a photocationic polymerization initiator, wherein the component (A) has a fluorine atom content of 1 mass% or less.

2. A negative type photosensitive resin composition as set forth in claim 1, wherein the component (A) contains a diamine residue derived from at least one diamine as represented by any of the general formulae (1) to (4) given below:

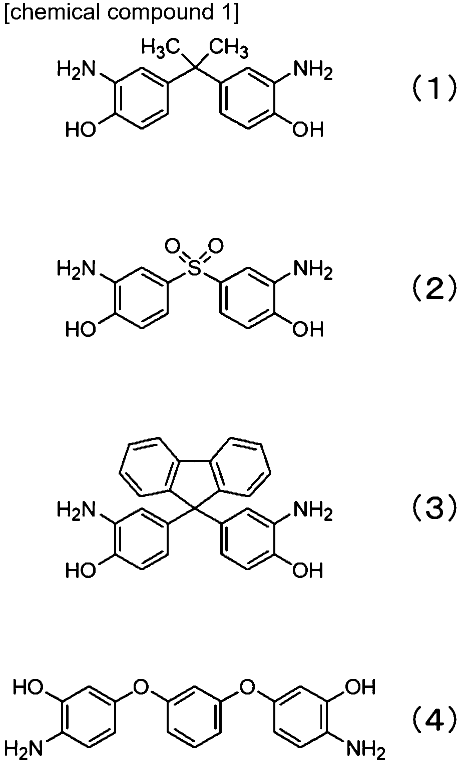

3. A negative type photosensitive resin composition as set forth in claim 2, wherein diamine residues derived from diamines as represented by any of the general formulae (1) to (4) altogether account for 50 to 100 mol% of the total amount, which accounts for 100 mol%, of all diamine residues present in the component (A).

4. A negative type photosensitive resin composition as set forth in claim 2, wherein diamine residues derived from diamines as represented by either the general formulae (3) or (4) altogether account for 50 to 100 mol% of the total amount, which accounts for 100 mol%, of all diamine residues present in the component (A).

5. A negative type photosensitive resin composition as set forth in claim 1, wherein the component (A) contains a diamine residue derived from a diamine as represented by the general formula (5) given below:

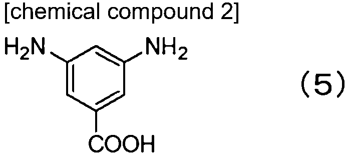

6. A negative type photosensitive resin composition as set forth in claim 1, wherein the component (A) contains an alicyclic structure.

7. A negative type photosensitive resin composition as set forth in claim 1, wherein the component (A) contains a carboxylic acid residue derived from an acid dianhydride as represented by the general formula (6) given below:

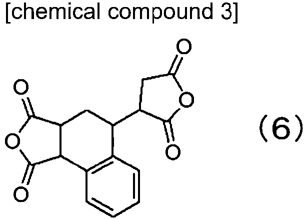

8. A negative type photosensitive resin composition as set forth in claim 4, wherein the component (A) contains a diamine residue derived from a diamine and the component (A) also contains a carboxylic acid residue, with the ratio Y/X of the total amount of diamine residues to the total amount of all carboxylic acid residues being in the range of 0.55 to 0.85 where X moles represents the total content of carboxylic acid residues while Y moles represents the total content of diamine residues present in the component (A).

9. A negative type photosensitive resin composition as set forth in claim 1, wherein the imidization rate of the component (A) is in the range of 70% to 100%.

10. A negative type photosensitive resin composition layer comprising a negative type photosensitive resin composition as set forth in claim 1.

11. A negative type photosensitive resin composition film comprising a negative type photosensitive resin composition layer as set forth in claim 10 and a support.

12. A cured layer produced by curing a negative type photosensitive resin composition as set forth in claim 1 or by curing a negative type photosensitive resin composition layer as set forth in claim 10.

13. A semiconductor device comprising a cured layer as set forth in claim 12.

14. A semiconductor device as set forth in claim 13 having an aluminum pad electrode.
